(19) Europäisches Patentamt
European Patent Office
Office européen des brevets

(11) EP 3 384 074 B1

# (12) FASCICULE DE BREVET EUROPEEN

(45) Date de publication et mention de la délivrance du brevet:
**30.06.2021 Bulletin 2021/26**

(21) Numéro de dépôt: **16819151.8**

(22) Date de dépôt: **02.12.2016**

(51) Int Cl.:
***C30B 29/58*** *(2006.01)* ***B01L 3/00*** *(2006.01)*
***C30B 7/08*** *(2006.01)* ***C30B 7/14*** *(2006.01)*

(86) Numéro de dépôt international:
**PCT/FR2016/053185**

(87) Numéro de publication internationale:
**WO 2017/093689 (08.06.2017 Gazette 2017/23)**

## (54) PUCE MICROFLUIDIQUE POUR LA CRISTALLISATION DE MOLECULES, PROCEDE DE PREPARATION, DISPOSITIF LA COMPRENANT ET PROCEDE DE CRISTALLISATION DE MOLECULES

MIKROFLUIDISCHER CHIP FÜR MOLEKÜLKRISTALLISATION, HERSTELLUNGSVERFAHREN, VORRICHTUNG DAMIT UND MOLEKÜLKRISTALLISATIONSVERFAHREN

MICROFLUIDIC CHIP FOR MOLECULE CRYSTALLISATION, PREPARATION METHOD, DEVICE COMPRISING SAME AND MOLECULE CRYSTALLISATION METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2015 FR 1561715**

(43) Date de publication de la demande:
**10.10.2018 Bulletin 2018/41**

(73) Titulaire: **Université Grenoble Alpes**
**38400 Saint-Martin-d'Hères (FR)**

(72) Inventeurs:
- **SPANO, Monika**
**38850 Charavines (FR)**
- **SALMON, Jean-Baptiste**
**33800 Bordeaux (FR)**
- **JUNIUS, Niels Heinz**
**38000 Grenoble (FR)**

(74) Mandataire: **Hautier, Nicolas**
**Cabinet Hautier**
**20, rue de la Liberté**
**06000 Nice (FR)**

(56) Documents cités:
**WO-A1-2004/023106 FR-A1- 2 964 671**
**US-A1- 2014 080 206**

- **LONGUET CLOTHILDE ET AL: "Spatially-controlled protein crystallization in microfluidic chambers", JOURNAL OF CRYSTAL GROWTH, vol. 386, 15 janvier 2014 (2014-01-15), pages 179-182, XP028776143, ISSN: 0022-0248, DOI: 10.1016/J.JCRYSGRO.2013.10.011**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

### DOMAINE DE L'INVENTION

La présente invention concerne une puce microfluidique pour la cristallisation de molécules, avantageusement de macromolécules biologiques, en particulier de protéines. Ainsi, la présente invention concerne le domaine de la cristallisation de molécules, avantageusement de macromolécules biologiques, telles que des protéines.

L'activité biologique de la plupart des protéines est déterminée par leur structure 3D, c'est à dire la manière dont les acides aminés de la chaîne polypeptidique sont agencés les uns par rapport aux autres dans l'espace. Par exemple, un nombre important de maladies moléculaires est causé par des modifications de structure de protéine. Les médicaments fonctionnent en se liant à des protéines, ce qui induit une modification de leur structure fonctionnelle en affectant ainsi leur activité biologique. La conception et l'amélioration des médicaments sont grandement facilitées par la connaissance des structures 3D de leurs cibles macromoléculaires. L'élucidation de la structure 3D des protéines est ainsi d'une importance primordiale pour comprendre les mécanismes sous-jacents des maladies moléculaires. Afin d'étudier cette structure 3D, on a essentiellement recours à des techniques de diffraction aux rayons X.

La technique de diffraction nécessite que les macromolécules à étudier se trouvent sous la forme cristalline, et plus avantageusement sous la forme de monocristaux de bonne qualité et de volume suffisant.

Dans le cadre de la présente invention, on entend par monocristal de bonne qualité, un cristal unique présentant :

- une faible mosaïcité,
- un pouvoir de diffraction important (à savoir inférieur à 2 angström),
- une taille comprise entre 1 et 100 μm.

Pour obtenir des monocristaux de bonne qualité et de volume suffisant, il est essentiel de contrôler la cristallisation des macromolécules (à savoir la cristallogenèse). Le processus de cristallisation traite à la fois des caractéristiques thermodynamiques et cinétiques dans les espaces de phase multidimensionnels. Les données thermodynamiques sont les courbes de solubilité, la présence de phases métastables, les polymorphes, la séparation liquide-liquide... Et elles dépendent de plusieurs paramètres tels que la température, le pH, le solvant, les impuretés, etc. En outre, les trajectoires cinétiques dans le diagramme de phase sont pertinentes pour contrôler la plupart des propriétés finales des cristaux synthétisés. Le chemin suivi dans le diagramme de phase contrôle la nucléation et la croissance des cristaux, et donc leur nombre, la taille et la morphologie.

La cristallogenèse comporte deux étapes :

- une première étape, dite de nucléation, consistant en l'apparition de germes cristallins à partir d'une solution de cristallisation.
- une deuxième étape, dite de croissance, consistant en la croissance cristalline des germes de cristaux obtenus lors de la nucléation.

Pour une meilleure compréhension de la cristallisation il est important de réaliser un diagramme de phases de la molécule à cristalliser qui est établi en fonction de la température, de la concentration en soluté, et/ou de la concentration en agent précipitant. On distingue sur un tel type de diagramme quatre zones:

- La zone métastable, dans laquelle la solution est faiblement sursaturée, et peut se maintenir ainsi très longtemps sans formation de cristaux, mais les cristaux ensemencés y grossissent ;
- La zone de sous-saturation: La nucléation n'a pas lieu et les cristaux ensemencés sont dissous;
- Le zone de nucléation spontanée : L'excès de la molécule à cristalliser se sépare de la solution de la molécule à cristalliser sous la forme de germes de cristaux (ou autrement dit de nucléis). Les cristaux ensemencés y grossissent.
- La zone de précipitation : zone dans laquelle la sursaturation est tellement importante que la formation des agrégats et des précipités y est favorisée avant la formation des cristaux. Les structures formées sont désordonnées. Il s'agit d'agrégats et/ou de précipités.

Les zones métastable, de nucléation spontanée et de précipitation forment ensemble la zone dite « zone de sursaturation ». La limite supérieure de la zone métastable (à savoir la frontière entre la zone métastable et la zone de nucléation spontanée) est aussi dénommée « limite de métastabilité » ou « courbe de supersolubilité ».

Il a été d'abord supposé que toute protéine qui pourrait être solubilisée et purifiée serait relativement facile à cristalliser. Cependant, les résultats ont indiqué que la solubilité et la pureté des protéines, bien que constituant des facteurs importants, ne garantissent pas un rendement de cristaux utiles. Le comportement des protéines en cristallisation s'avère très complexe.

Néanmoins, la croissance des cristaux macromoléculaires, et ainsi la production croissante des cristaux des protéines, des acides nucléiques, et des virus, est aujourd'hui un outil des biologistes moléculaires et structurales. La corrélation structure-fonction est désormais de rigueur en enzymologie, de même que la conception des médicaments basée sur les structures cristallines des complexes devient indispensable. L'exploitation des résultats cristallographiques pour expliquer et décrire les phénomènes naturels continu à croître, l'extension des méthodes aux problèmes structuraux plus compliqués mène à accroitre des tentatives pour cristalliser encore plus de macromolécules. Cela, à son tour, inspire un besoin en techniques plus efficaces et plus rapides pour croître ces cristaux.

La mise en place des essais de cristallisation de protéines et l'analyse des résultats est devenue en grande partie automatisée. Le laboratoire de cristallisation peut ainsi comprendre l'utilisation :

- de robots de distribution : distribution de solution de réservoir, distribution de goutte de cristallisation, distribution de solution de réservoir et de goutte de cristallisation
- de robots d'imagerie variant des microscopes semi-automatiques aux incubateurs entièrement automatisés.

Lorsque les cristaux sont trouvés, une évaluation doit être faite pour déterminer si les cristaux sont en effet des cristaux de protéines ou de type non-protéinique (e.g. des cristaux de sel). Et la qualité du cristal doit être évaluée ainsi que son utilité pour la collecte des données de diffraction. Cette analyse s'effectue de préférence *in situ.* Ces dernières années, trois nouvelles techniques ont été développées dans ce domaine : l'analyse de diffraction *in situ* (Skarzynski, 2009 ; Le Maire *et al.,* 2011), la détection UV (Judge *et al.,* 2005; Debois et *al.,* 2013) et la microscopie de la deuxième/seconde harmonique (SONICC ; Wampler *et al.,* 2008 ; Kissick *et al.,* 2011).

En parallèle avec l'automatisation concernant de nombreux laboratoires de cristallisation, le dernier maillon dans « la pipeline » de l'analyse des protéines est l'analyse de diffraction dans le faisceau des rayons X. Et cette partie est devenue aussi automatisée. De nos jours, le montage et la congélation des cristaux est même envisageable à partir des plaques de cristallisation standard au format SBS, à l'aide d'une pince en kapton attachée sur un bras robotisée (Heidari Khajepour *et al.* ; 2012). Les cristaux montés au laboratoire de l'utilisateur sont emballés dans un Dewar spécifique, leur montage étant compatible avec le bras du robot de la ligne de lumière où les cristaux vont être analysés, et ils sont envoyés au synchrotron.

Des plateformes de cristallisation qui comprennent les plaques de diffusion de vapeur (Bingel-Erlenmeyer *et al.,* 2011; Axford *et al.,* 2012; Cipriani *et al.,* 2012), les puces microfluidiques (Pinker *et al.,* 2013; Heymann *et al.,* 2014; Perry *et al.,* 2014), les boucles accoustiquement chargées (Yin *et al.,* 2014), les microcapillaires (Pineda-Molina *et al.,* 2012) et avec les nanogouttes (Maeki *et al.,* 2012) permettent au moins en principe, de tester les cristaux *in situ,* une considération importante lors du dépistage de la qualité de diffraction aux rayons X.

Grâce au rayonnement synchrotron intense, la cryocristallographie et les méthodes directes de phasage, un seul cristal peut suffire. Mais il faut que ce soit un très bon cristal (cristal de très bonne qualité cristalline), même s'il est petit (de l'ordre de $\leq 10\mu m$). Le rayonnement intense peut détruire un cristal de protéine, même s'il est congelé. La congélation elle-même peut fissurer un cristal en morceaux ou en augmenter la mosaïcité. Des méthodes directes ne peuvent pas être utilisées si le cristal ne diffracte pas à très haute résolution. Donc, des problèmes demeurent, même pour les structures moins exigeantes.

***Vers la miniaturisation de la cristallisation : cristallisation en microfluidique***

Les outils miniaturisés fluidiques permettent un contrôle unique des voies cinétiques subies dans un diagramme de phase ainsi qu'un aperçu approfondi dans les processus de nucléation et de croissance des cristaux de molécules inorganiques et biologiques.

Les avantages de la microfluidique sont d'étudier la cristallisation avec des objectifs spécifiques : nous pouvons vouloir recueillir des données thermodynamiques et cinétiques, ou cultiver des cristaux exploitables dans le but d'effectuer des études de diffraction.

En fait, la microfluidique offre une gamme d'outils qui sont utiles pour multiplier les expériences et/ou mettre l'accent sur un point précis pour dévoiler les mécanismes fondamentaux. La technologie microfluidique est une boîte à outils pour manipuler des liquides dans les réseaux de microcanaux avec les échelles de 1-100 $\mu m$ en longueur. Ces réseaux imitent les expériences classiques effectuées dans un laboratoire, mais avec un contrôle inégalé du point de vue des phénomènes de transport (Squires & Quake, 2005 ; Vilkner *et al.,* 2004 ; Stone *et al.,* 2004). Dans le contexte spécifique de la cristallisation (Van der Woerd *et al.,* 2003 ; Sauter *et al.,* 2007), ces outils microfluidiques permettent essentiellement la manipulation de solutions aqueuses autour de la température ambiante. A l'origine, le domaine d'application était assez limité mais les progrès constants de la technologie microfluidique offrent désormais des fonctionnalités originales qui permettent au chercheur de:

1. Effectuer l'acquisition de données à haut débit en utilisant des tests de cristallisation avec un volume aussi faible

que 1 nL ;

2. Concevoir les voies cinétiques spécifiques en utilisant un excellent contrôle de transfert de masse et transfert de chaleur dues à la réduction des échelles de longueur et à l'intégration, sur puce, des capteurs et des actionneurs ;

3. Apporter des nouvelles conditions expérimentales pour étudier la cristallisation, sans turbulences, sans ou avec peu d'effet de gravité, le confinement, et grand rapport surface/volume. En outre, les faibles volumes V utilisés en microfluidique ont un intérêt particulier pour la nucléation. Le temps moyen de nucléation ($\alpha$ 1/V) peut dépasser la cinétique de croissance des cristaux (Kashchiev *et al.,* 1991) et un seul événement de nucléation est donc statistiquement observé. Ce mécanisme mononucléaire est essentiel pour estimer la cinétique de nucléation et d'étudier le polymorphisme.

Beaucoup de cibles médicamenteuses sont des protéines membranaires intégrales qui sont expérimentalement particulièrement exigeantes. Pour de tels objets difficiles, peu de plateformes de cristallisation existent et peu de structures sont résolues (Huang *et al.,* 2015). Des centaines de très petits cristaux sont souvent testés avant qu'un jeu des données complet puisse être collecté en raison des dégâts causés par l'irradiation ou par la congélation. La qualité des données ainsi obtenues est souvent inférieure à celle qui pourrait l'être avec des cristaux plus gros (Rice *et al.,* 2000) ou non congelés, testés par la diffraction *in-situ* à température ambiante. En fusionnant des données de diffraction incomplètes, obtenues à partir de plusieurs cristaux isomorphes à température ambiante, un ensemble complet des données peut être obtenu pour la détermination de la structure 3D. Cette approche élimine la nécessité de récupérer les cristaux et les congeler, et évite en même temps les effets néfastes dus à l'irradiation avec une collecte des données de diffraction en série à température ambiante. Par conséquent, il est donc nécessaire de pouvoir augmenter la taille, la qualité du cristal ainsi que de concevoir des supports de croissance de ces cristaux éliminant toute manipulation postérieure des cristaux et permettant les expériences de diffraction *in-situ,* pour rendre les expériences de diffraction significativement plus faciles, plus rapides et pour un coût moins important.

La dialyse est un procédé de séparation par membrane des molécules ou des ions en solution au même titre que l'osmose inverse, l'ultrafiltration et l'électrodialyse. Ces techniques diffèrent par la force utilisée pour que les espèces chimiques ou les ions puissent traverser la membrane semi-perméable, c'est-à-dire la barrière relativement mince séparant deux milieux liquides. Ces forces sont un gradient de concentration dans la dialyse. L'avantage de cette dernière réside dans le fait qu'elle n'entraîne aucune consommation d'énergie, et empêche l'accumulation de constituants dans la membrane, ce qui permet d'envisager un fonctionnement en continu. La dialyse est une forme de filtration moléculaire : elle permet de séparer les molécules selon leur taille, en utilisant des membranes semi-perméables dont les pores ont une taille inférieure aux dimensions macromoléculaires. Ces pores laissent diffuser les petites molécules, telles que celles du solvant, des sels, et de petits métabolites, au travers de la membrane mais bloquent le passage de molécules plus grandes.

La cristallisation par dialyse implique la mise en place de la molécule à cristalliser dans un dispositif qui est scellé au moyen d'une membrane de dialyse. Cela permet alors à l'eau, des agents de cristallisation, des additifs ou encore des tampons de diffuser de part et d'autre de la membrane de dialyse tout en conservant la molécule à cristalliser dans le dispositif. Le dispositif est placé dans un conteneur approprié qui renferme les agents de cristallisation, les additifs et les tampons. Cette technique par dialyse tient compte aussi bien des effets « salting in » (à basse force ionique, la solubilité de la molécule à cristalliser augmente lorsque la force ionique augmente) et des effets « salting out » (à haute force ionique, la solubilité de la molécule à cristalliser diminue lorsque la force ionique augmente) que du pH.

La demande WO2012/035268 décrit un dispositif de cristallisation, dans lequel la cristallisation est mise en œuvre en faisant varier de manière contrôlée et *in situ* la composition de la solution de cristallisation. Cette mise en œuvre de la cristallisation présente l'intérêt de nécessiter un volume de l'échantillon de la molécule à cristalliser utilisé dans une seule expérimentation réduit par rapport aux techniques classiques de cristallisation avec la possibilité de le réutiliser ultérieurement. En effet, l'échantillon n'est pas consommé au cours de la cristallisation et les conditions de cristallisation peuvent être changées de façon réversible, et ceci autant de fois que la protéine n'est pas endommagée (*e.g.* dénaturée) dans les conditions de cristallisation sélectionnées. Ce dispositif comprend une cellule à dialyse et un réservoir permettant la dialyse en flux continue contre une solution de composition contrôlée, permettant le contrôle de composition chimique (e.g. concentration du précipitant, pH, additifs,...). Le dispositif permet également le contrôle précis de la température avec l'observation en temps réel des solutions de cristallisation. Le système permet l'exploration d'une multitude de conditions de cristallisation avec le même échantillon de protéine (15 $\mu$L de protéine par expérience). Cette approche permet des expériences en série au lieu d'expériences parallèles.

L'objectif de la présente invention consiste à miniaturiser un tel dispositif, sous la forme d'une puce microfluidique et d'accéder ainsi à un procédé de cristallisation de macromolécules performant.

Cette puce pourra être directement placée dans le rayonnement d'un synchrotron, ce qui permet de collecter les données de diffraction sur nombreux cristaux isomorphes résidant dans la puce et de s'affranchir de l'obtention de gros cristaux. La diffraction des rayons X peut se faire directement sur la puce, à température contrôlée (le plus souvent à température ambiante), permettant ainsi de s'affranchir d'une étape de congélation ; la congélation pouvant en outre

dégrader le cristal.

Le procédé de cristallisation par dialyse, mis en œuvre avec la puce selon l'invention, permet en outre:

- d'identifier le moment où on approche des conditions de cristallisation
- de connaître le comportement des germes cristallins une fois formés et présents dans une solution de molécule à cristalliser.

Nous visons à miniaturiser l'optimisation de la cristallisation des macromolécules notamment biologiques tout en permettant la diffraction *in situ.* La miniaturisation permettra de revisiter différents phénomènes sous de nouvelles conditions expérimentales et d'intégrer les éléments de contrôle précis (e.g. température, concentration du précipitant), et donc de maîtriser le chemin cinétique suivant le diagramme de phase, et ceci avec une grande précision. Cette plateforme microfluidique de cristallisation automatisée permet d'accélérer l'obtention de cristaux et d'augmenter la qualité cristalline en réduisant les manipulations que ceux-ci subissent tout en minimisant le volume d'échantillon nécessaire.

Au-delà de l'apport de ce travail de microfabrication et notamment en ce qui concerne l'intégration de membranes de dialyse, la réussite du projet concerne avant tout la biologie structurale. La capacité de la plateforme microfluidique à recueillir des données cristallographiques *in situ* d'un grand nombre de cristaux de protéines offre la possibilité d'utiliser le rayonnement synchrotron non seulement pour la cristallographie en série mais aussi pour la cristallographie résolue dans le temps (la diffraction Laue) et, par conséquent pour l'étude structurale de la dynamique des réactions biochimiques. L'enjeu majeur vient de l'intégration des capacités du traitement des fluides permettant au flux continu de déclencher les réactions enzymatiques pour une analyse cristallographique dynamique.

La définition de microfluidique que l'on peut trouver dans le dictionnaire Larousse est la suivante : « Branche de la mécanique des fluides étudiant ceux qui circulent dans des canaux de quelques micromètres de diamètre. ». On peut considérer qu'un système microfluidique peut être défini comme tel à partir du moment où une de ses longueurs caractéristique est comprise entre 1$\mu$m et 1mm.

<u>Écoulement en micro-canal :</u>

En microfluidique, il est nécessaire de tenir compte des effets des écoulements dans les micro-canaux. Cependant au vu des dimensions de travail, de l'ordre du micromètre jusqu'au millimètre, la physique classique est de rigueur même si les forces de contact jouent un rôle plus important à cette échelle qu'à l'échelle macroscopique.

Le mouvement d'un fluide monophasique dans l'approche hydrodynamique est régi par 2 équations. L'équation de conservation de la quantité de mouvement (1) et l'équation de conservation de la masse (2).

$$\rho \frac{D\vec{u}}{Dt} = \vec{\nabla} \cdot \vec{\vec{\tau}} + \vec{F} \quad (1)$$

Avec :

$\rho = \rho(\vec{x},t)$ masse volumique (kg.m-3)
$\vec{u} = \vec{u}(\vec{x},t)$ vitesse (m.s-1)
$\vec{\vec{\tau}} = \vec{\vec{\tau}}(\vec{x},t) = (\tau_{ij})$ tenseur des contraintes visqueuses
$\vec{F}$ forces extérieures (N)

$$\frac{D\rho}{Dt} + \rho \vec{\nabla} \cdot \vec{u} = 0 \quad (2)$$

$\frac{D}{Dt}$ est la dérivée particulaire que l'on peut retrouver en considérant une fonction f de l'espace et du temps. Lors d'un mouvement d'une particule fluide durant dt selon x la particule aura parcouru dx=x+vdt, on aura donc :

$$df = f(x + vdt, t + dt) - f(x, t) = \frac{\partial f}{\partial x} dx + \frac{\partial f}{\partial t} dt$$

Donc $df = \frac{\partial f}{\partial x} vdt + \frac{\partial f}{\partial t} dt$ d'où

$$\frac{Df}{Dt} = \frac{\partial f}{\partial x} v + \frac{\partial f}{\partial t} \quad (3)$$

En hydrodynamique on considère souvent que le fluide est incompressible lorsque sa vitesse est bien inférieure à la vitesse du son. Cependant il peut arriver dans certains cas qu'il ne soit pas possible de considérer le fluide comme incompressible. Ce système d'équation peut être complété par des équations d'états thermodynamiques ou d'autres équations de conservation en fonction du système étudié.

Dans le cas des fluides Newtoniens on peut modifier l'équation de conservation de la quantité de mouvement de la sorte :

$$\rho \frac{D\vec{u}}{Dt} = -\vec{\nabla} p + \mu \Delta \vec{u} + \vec{F} \quad (4)$$

Ici le tenseur des contraintes visqueuses est relié de manière simple à la vitesse car il s'agit d'un cas particulier, $\mu$ désigne la viscosité dynamique du fluide. L'équation (4) est appelée équation de Navier-Stokes.

Dans le cas d'un canal de section rectangulaire de largeur $\omega$, de hauteur h et de longueur L (très grande devant $\omega$ et h), si on considère le fluide comme incompressible et que l'on est dans un écoulement permanent avec une vitesse d'écoulement selon x, alors on en déduit que :

$$\frac{dp}{dx} = \mu \left( \frac{\partial^2 u}{\partial y^2} + \frac{\partial^2 u}{\partial z^2} \right) \quad (5)$$

La pression varie longitudinalement et on peut introduire la perte de charge $\Delta p$ pour une longueur L du canal :

$$\frac{\Delta p}{L} = \frac{p - p0}{x - x0} \rightarrow \frac{\partial^2 u}{\partial y^2} + \frac{\partial^2 u}{\partial z^2} = \frac{-\Delta p}{\mu L} \quad (6)$$

Or dans notre cas particulier on obtient pour la vitesse, en résolvant (6), le résultat de Poiseuille plan. En intégrant sur la section rectangulaire on trouve une relation entre le débit volumique Q et la perte de charge.

On a alors :

$$Q = \frac{\Delta p}{12 \mu L} \omega h^3 \quad (7)$$

Par analogie avec les circuits électriques on peut donc enfin définir la notion de résistance hydrodynamique en considérant que $Q = R\,\Delta p \leftrightarrow U = Ri$

L'objectif de l'invention consiste à concevoir une puce microfluidique intégrant une membrane de dialyse parmi les plus largement utilisées en cristallisation des protéines, à savoir en cellulose régénérée. Cette puce doit aussi répondre à plusieurs contraintes, elle doit :

- être conçue dans un matériau « transparent » pour les rayons X dans les énergies utilisées au synchrotron (ne provoquant pas de diffusion ni d'absorption significatives des rayons X)
- être compatible avec le matériel biologique
- permettre de contenir un faible volume de protéine, de l'ordre ou inférieur au microlitre
- posséder un canal par lequel on puisse introduire et modifier la solution permettant la mise en œuvre du procédé de cristallisation pour travailler dans de nouvelles conditions
- être contrôlée en température

En effet, cette invention a pour but de concevoir un outil microfluidique pour la cristallisation des protéines qui serait une miniaturisation d'un instrument existant permettant le contrôle et l'optimisation de la croissance cristalline [dispositif décrit dans la demande WO2012/035268].

L'invention a pour objectif le développement d'une plateforme microfluidique séquentielle pour la cristallisation des macromolécules telles que des protéines qui combine le contrôle de température et de composition chimique de la solution permettant la mise en œuvre du procédé de cristallisation par la méthode de dialyse dans une installation conviviale assurant : i) la recherche de conditions de cristallisation et leur optimisation, ii) le suivi de la cristallisation *in situ* basé sur les diagrammes de phases déterminés expérimentalement, iii) l'analyse des cristaux *in situ* par diffraction des rayons X et iv) la résolution de la structure des protéines via la diffraction « on chip » des cristaux isomorphes aux rayons X.

L'objectif est notamment de contrôler précisément et de façon réversible la cristallisation via la microdialyse et le contrôle de la température. Cela aura d'énormes avantages, en particulier pour la cristallisation des protéines membranaires où à la fois la protéine et le détergent sont coûteux. Un tel dispositif sera également extrêmement précieux pour la cristallisation en phase cubique, où la compréhension approfondie de l'espace de phases permettrait de trouver la meilleure façon d'obtenir des cristaux.

La demande de brevet US 2014/080206 décrit une puce microfluidique fabriquée selon un procédé conforme à l'exemple comparatif 1. Ce système n'est toutefois pas satisfaisant car on a observé que la membrane ne résistait pas (se décollait) lorsque l'on fait couler du liquide dans la puce.

L'article longuet et al., « spatially-controlled protein crystallisation in microfluidic chambers », journal of crystal growth, vol. 386, pages 179-182, décrit une puce microfluidique en PDMS, la membrane est ici maintenue entre deux blocs scellés par collage. Ce système n'est toutefois pas satisfaisant car on a observé que la membrane ne résistait pas (se décollait) lorsque l'on fait couler du liquide dans la puce.

## BREVE DESCRIPTION DE L'INVENTION

L'invention a pour objet une puce microfluidique (1) comprenant au moins une cellule (11) de cristallisation à dialyse, ladite cellule (11) comprenant :

- un support (1111) en PMMA
- un premier étage comprenant un réservoir (111) délimité au moins en partie par ledit support (1111) et par une paroi externe (1112) de la cellule, ledit réservoir (111) étant en communication fluidique avec un canal d'entrée et un canal de sortie d'une solution permettant la mise en œuvre du procédé de cristallisation,
- un second étage comprenant une chambre de dialyse (113) délimitée au moins en partie par une paroi interne (1113) de la cellule sans contact avec le support (1111) et par une membrane de dialyse (112) formant une interface entre le réservoir (111) et la chambre de dialyse (113), la paroi interne (1113) comprenant au moins une portion d'un seul tenant dans laquelle la périphérie de ladite membrane (112) est maintenue scellée.

Avantageusement, la chambre de dialyse contient une solution de molécule à cristalliser et en ce que la chambre de dialyse est scellée par une couche de polymère en PMMA (1115).

Il existe avantageusement un espace entre les parois externes (1112) et internes (1113) débouchant sur une surface principale (1114) de la puce et en ce que cet espace, en surface de la puce, est connecté via un raccord au système de contrôle des écoulements des fluides (1116),

La membrane de dialyse est avantageusement en cellulose, plus avantageusement en cellulose régénérée.

Le volume de la chambre de dialyse est avantageusement compris entre 0,1 et 1 $\mu$L.

La puce microfluidique (1) selon l'invention comprend avantageusement plusieurs cellules de cristallisation à dialyse alignées en lignes et colonnes.

L'invention a également pour objet un procédé de préparation d'une puce microfluidique (1) selon l'invention, caractérisé en ce qu'il comprend les étapes successives suivantes :

- Réaliser deux blocs structurés en polymère réticulé perméable à l'air PL pour obtenir les tampons 3D en ledit

polymère PL de la partie haute qui définira la chambre de dialyse et de la partie basse de la puce qui définira les canaux et le(s) réservoir(s),

- Sur le bloc structuré avec les canaux et le(s) réservoir(s) déposer une ou plusieurs membrane(s) de dialyse sèche(s),
- Placer le bloc structuré sans canaux en coïncidence avec le bloc structuré avec les canaux de manière à prendre en sandwich la membrane,
- Déposer une résine photosensible NOA81® sur 3 côtés entre les deux blocs structurés puis initier la réticulation de ladite résine NOA81®,
- Retirer la partie supérieure du bloc structuré avec l'assemblage en résine réticulée en décollant le tout du bloc structuré du bas,
- Refermer la partie visible (sans PL) avec une lamelle de PMMA,
- Finaliser la réticulation de ladite résine NOA81®,
- Retirer le dernier bloc structuré

L'invention a aussi pour objet un dispositif de cristallisation d'une molécule à cristalliser qui comprend

- Au moins une puce microfluidique selon l'invention
- Au moins un moyen d'ajout agencé pour ajouter dans la chambre de dialyse une solution S1 comprenant la molécule à cristalliser et éventuellement au moins un tampon
- Au moins un moyen d'ajout / prélèvement agencé d'agent de cristallisation et/ou d'additif(s) et/ou tampon(s) et ainsi de la composition de la solution permettant la mise en œuvre du procédé de cristallisation dans les canaux menant à la chambre du réservoir
- Au moins un moyen de contrôle de la composition chimique de la solution dans le réservoir, par exemple un moyen de dosage, de variation de la concentration des tampons, des agents de cristallisation et des additifs
- Au moins un moyen de contrôle et de variation de la température de la puce microfluidique selon l'invention
- Eventuellement au moins un moyen de mesure de la concentration de la molécule à cristalliser dans la solution S1
- Au moins un moyen d'acquisition d'images

L'invention a également pour objet un procédé de cristallisation d'une molécule à cristalliser, caractérisé en ce qu'il comprend les étapes successives suivantes :

a) On ajoute une solution S1 comprenant la molécule à cristalliser dans la chambre de dialyse (113) de la puce microfluidique (1) selon l'invention puis on l'encapsule.
b) Le cas échéant, on injecte en continu une solution S2 dans les canaux de ladite puce microfluidique (1), ladite solution S2 contenant uniquement le tampon, la pression d'injection au niveau du canal microfluidique est maintenue inférieure à 400 mbar.
c) On injecte en continu une solution S3 de cristallisation, dans les canaux de ladite puce microfluidique (1), la pression d'injection au niveau du canal microfluidique est maintenue inférieure à 400 mbar.

La solution S3 de cristallisation contient au moins un agent de cristallisation et le cas échéant un ou plusieurs additifs, et éventuellement un tampon. Lorsque l'étape b) du procédé est mise en œuvre, la solution S3 comprend le tampon de la solution S2 et au moins un agent de cristallisation le cas échéant un ou plusieurs additifs.
Avantageusement, lors de l'étape a) la chambre de dialyse est encapsulée par dépôt d'une lamelle de PMMA, puis revêtement KAPTON®.
Avantageusement :

- Lors de l'étape a), le cas échéant lors de l'étape b), la solution contenue dans la chambre de dialyse, comprenant ladite molécule à cristalliser, est à une première température T1 et à une concentration C1 de la molécule à cristalliser de telle sorte que la molécule à cristalliser se trouve dans la zone de sous-saturation (en dessous de la courbe de solubilité) du diagramme de phases de ladite molécule à cristalliser établi en fonction des paramètres de la concentration de la molécule à cristalliser et de la température. Lors de l'étape b), le tampon présent dans la solution S2 diffuse dans la solution contenue dans la chambre de dialyse et la molécule à cristalliser se trouve toujours dans ladite zone de sous-saturation
- Lors de l'étape c), ladite solution de cristallisation S3 contient, le cas échéant en plus du tampon, au moins un agent de cristallisation et le cas échéant un ou plusieurs additifs à une concentration P constante, de manière à ce que l'agent de cristallisation et le cas échéant l'additif diffuse dans la solution contenue dans la chambre de dialyse et de telle sorte que la molécule à cristalliser se trouve dans la zone de nucléation spontanée ou sur la limite supérieure de la zone métastable du diagramme de phases de ladite molécule à cristalliser et qu'apparaissent des germes de la molécule à cristalliser ;

Et le procédé comprend ensuite les étapes successives suivantes :

d) on augmente la température de la cellule de cristallisation (11) à une température T2 de telle sorte que la nucléation est arrêtée et que la molécule à cristalliser se trouve dans la zone métastable du diagramme de phases de la molécule à cristalliser,
e) s'il y a la formation de trop nombreux cristaux pendant l'étape c), la température de la cellule de cristallisation (11) peut-être augmentée à une température >T2 de telle manière que la molécule à cristalliser se retrouve dans la zone de sous-saturation, juste en dessous de la courbe de solubilité, à nouveau et que l'excès de petits cristaux soient complètement dissout. Quelques cristaux sélectionnés, de tailles supérieures vont subir une dissolution partielle en évitant la dissolution complète et vont ensuite croitre dans la zone métastable par la baisse de température à la température T2
f) On laisse grossir les germes de cristaux à la température T2 jusqu'à l'obtention d'un premier point d'équilibre E1, où la taille des cristaux demeure constante, la concentration de la molécule à cristalliser dans la solution contenue dans la chambre de dialyse atteinte étant alors la concentration C2,
g) On abaisse la température de la cellule de cristallisation (11) à une température T3, de telle sorte que les cristaux présents dans la chambre de dialyse (113) se situent toujours dans la zone métastable du diagramme de phases de la molécule à cristalliser
h) On laisse grossir les germes de cristaux et les cristaux à la température T3 jusqu'à l'obtention d'un deuxième point d'équilibre E2 où la taille des cristaux demeure constante, la concentration de la molécule à cristalliser dans la solution contenue dans la chambre de dialyse atteinte étant alors la concentration C3
i) On répète éventuellement les étapes f) à h)
j) On récupère la puce contenant les cristaux obtenus à l'issue de l'étape h) ou i) pour l'expérience de diffraction aux rayons X *in situ.*

Avantageusement :

- Lors de l'étape a), le cas échéant lors de l'étape b), la solution contenue dans la chambre de dialyse est à une température constante T de la cellule de cristallisation (11) et à une concentration C1 de la molécule à cristalliser de telle sorte que la molécule à cristalliser se trouve dans la zone de sous-saturation (en dessous de la courbe de solubilité) du diagramme de phases de ladite molécule à cristalliser établi en fonction des paramètres de la concentration de la molécule à cristalliser et de la concentration en agent de cristallisation et le cas échéant de la concentration en additif(s); lors de l'étape b), le tampon présent dans la solution S2 diffuse dans la solution contenue dans la chambre de dialyse et la molécule à cristalliser se trouve toujours dans ladite zone de sous-saturation
- Lors de l'étape c), ladite solution de cristallisation S3 contient, le cas échéant en plus du tampon au moins un agent de cristallisation et le cas échéant un ou plusieurs additifs à une concentration P1 dans le réservoir de la cellule de cristallisation, de manière à ce que l'agent de cristallisation et le cas échéant l'additif diffuse dans la solution contenue dans la chambre de dialyse et de telle sorte que la molécule à cristalliser se trouve dans la zone de nucléation spontanée ou sur la limite supérieure de la zone métastable du diagramme de phases de ladite molécule à cristalliser et qu'apparaissent des germes de la molécule à cristalliser ;
- Pour obtenir la nucléation spontanée contrôlée des cristaux la procédure suivante est employée : à l'aide du système de contrôle des écoulements des fluides la solution de cristallisation S3 est injectée en flux continu avec un gradient de concentration de l'agent de cristallisation et le cas échéant l'additif de manière à ce que, à la concentration P1, seulement quelques cristaux se forment.

et le procédé comprend ensuite les étapes successives suivantes :

d) On diminue la concentration de l'agent de cristallisation et le cas échéant de l'additif à une concentration P2, de telle sorte que la nucléation est arrêtée et que la molécule à cristalliser se trouve dans la zone métastable dudit diagramme de phases de la molécule à cristalliser
e) On laisse grossir les germes de cristaux à la concentration P2 de l'agent de cristallisation et le cas échéant de l'additif jusqu'à l'obtention d'un premier point d'équilibre E1, où la taille des cristaux demeure constante, la concentration de la molécule à cristalliser dans la solution contenue dans la chambre de dialyse atteinte étant alors la concentration C2
f)On augmente la concentration de l'agent de cristallisation et le cas échéant de l'additif à une concentration P3, de telle sorte que les cristaux présents dans la cellule de cristallisation (11) se situent toujours dans la zone métastable dudit diagramme de phases de la molécule à cristalliser,
g) On laisse grossir les germes de cristaux et les cristaux à la concentration P3 de l'agent de cristallisation et le cas échéant l'additif jusqu'à l'obtention d'un deuxième point d'équilibre E2 où la taille des cristaux demeure constante,

la concentration de la molécule à cristalliser dans la solution contenue dans la chambre de dialyse atteinte est la concentration C3,

h) On répète éventuellement les étapes d) à f)

i)On récupère la puce contenant les cristaux obtenus à l'issue de l'étape g) ou h) pour l'expérience de diffraction aux rayons X *in situ.*

## BREVE DESCRIPTION DES DESSINS

Fig. 1 cellule de cristallisation à dialyse (11) selon l'invention

Fig.2 mode de réalisation particulier de la cellule de cristallisation à dialyse (11) selon l'invention

Fig. 3 cellule de cristallisation à dialyse selon l'exemple comparatif 1

Fig 4. Schéma des étapes de remplissage du réservoir de protéine d'une cellule de cristallisation à dialyse selon l'exemple comparatif 2. Les croix représentent une entrée fermée.

Fig. 4A : remplissage avec une solution comprenant la molécule à cristalliser.

Fig 4B. la cellule est remplie de la solution comprenant la molécule à cristalliser

Fig 4C. on fait circuler l'huile de paraffine dans un premier côté de la cellule

Fig 4D. on fait circuler l'huile de paraffine dans l'autre côté de la cellule

Fig 5 schéma de représentation de la puce microfluidique selon l'invention déposée sur des éléments Peltier : d'un module Peltier à l'autre la température peut être différente.

1 :puce selon l'invention - 2 module Peltier - 21 : bloc cuivre - 211 :échangeur à eau - 212 : câblage Peltier

## DESCRIPTION DETAILLEE DE L'INVENTION

L'invention a pour objet une puce microfluidique (1), comprenant au moins une cellule (11) de cristallisation à dialyse, ladite cellule (11) comprenant :

- un support (1111) en PMMA
- un premier étage comprenant un réservoir (111) délimité au moins en partie par ledit support (1111) et par une paroi externe (1112) de la cellule, ledit réservoir (111) étant en communication fluidique avec un canal d'entrée et un canal de sortie d'une solution permettant la mise en œuvre du procédé de cristallisation,
- un second étage comprenant une chambre de dialyse (113) délimitée au moins en partie par une paroi interne (1113) de la cellule sans contact avec le support (1111) et par une membrane de dialyse (112) formant une interface entre le réservoir (111) et la chambre de dialyse (113), la paroi interne (1113) comprenant au moins une portion d'un seul tenant dans laquelle la périphérie de ladite membrane (112) est maintenue scellée.

Une caractéristique nécessaire de la puce (1) est qu'elle permet l'analyse et le suivi de la cristallisation des macromolécules par la microscopie optique d'une part et l'analyse des cristaux par RX d'autre part. Ainsi, elle doit être constituée de matériaux transparents vis à vis de la microscopie optique et des rayons X, au moins dans les zones qui seront observées au microscope d'une part et placées dans le rayonnement synchrotron d'autre part.

Le support de la puce est en PMMA (poly(méthacrylate de méthyle)). Le PMMA est choisi pour ses propriétés de transparence à la microscopie optique et aux rayons X. Ce polymère peut également être utilisé pour sceller la chambre de dialyse (113) après dépôt de la solution comprenant la macromolécule à cristalliser.

Avantageusement, la puce microfluidique (1) selon l'invention est caractérisée en ce que la chambre de dialyse contient une solution de molécule à cristalliser et en ce que la chambre de dialyse est scellée par une couche de polymère transparent aux rayons X et à la microscopie optique (1115), du PMMA.

Cette molécule est avantageusement une macromolécule, plus avantageusement une macromolécule biologique, en particulier une protéine. Cependant, la puce et le procédé selon l'invention peuvent également être utilisés pour d'autres molécules, comme par exemple des particules colloïdales ou une molécule difficile à cristalliser.

Le PMMA possède de nombreux avantages dont trois principaux : il est transparent, imperméable à l'air et résistant :

- très grande transparence, très limpide ;
- propriété optique excellente (transmission lumineuse supérieure à celle du verre jusque dans le proche UV, transparence, limpidité, brillance). Indice de réfraction de 1,49 ; il est transparent aux rayons X (ne provoque pas de diffusion ni d'absorption significatives des rayons X)
- excellente résistance aux agents atmosphériques ;

- excellente tenue aux rayons ultraviolets et à la corrosion.

Sur ce support, les motifs, à savoir le réservoir (111), les canaux, la chambre de dialyse (113), sont avantageusement formés dans une résine photosensible transparente à la microscopie optique.
A ce jour, on utilise la NOA81®. La Norland Optical Adhesive 81® ou NOA81® est une résine photosensible qui réticule en quelques secondes. Elle est transparente et son avantage dans notre cas provient du fait que l'oxygène inhibe la polymérisation des radicaux libres utilisé pour construire le réseau du polymère. Cette propriété permet d'envisager des puces à plusieurs étages ou de refermer la puce à l'aide d'une fine lame de PMMA par dessus de laquelle on applique avantageusement une fine couche de Kapton adhésif.
Le réservoir (111) est destiné à recevoir une solution permettant la mise en œuvre du procédé de cristallisation. Une telle solution comprend au moins un constituant choisi dans le groupe constitué par les agents de cristallisation, les additifs et les tampons.
Dans le cadre de la présente invention, on entend par agent de cristallisation, des agents qui favorisent la cristallisation de la molécule à cristalliser. Il peut s'agir de :

- sels, tels que le sulfate d'ammonium, le chlorure de sodium, le phosphate de potassium ;
- composés organiques, tels que l'isopropanol et le 2-methyl- 2,4-pentanediol (MPD) ;
- polyéthylène glycol, tels que le PEG 4000, le PEG 6000, ou encore le PEG 8000.

Dans le cadre de la présente invention, on entend par additif, des constituants permettant d'augmenter la stabilité de la molécule à cristalliser et/ou l'homogénéité de sa conformation. Il peut s'agir de détergents, d'agents réducteurs, de substrats, et de cofacteurs tels que les n-alkyl-glucosides ou n-alkyl-maltosides, le dithiotreitol (DTT), des lipides, des sous-unités ou des groupes prosthétiques.
Dans le cadre de la présente invention, on entend par tampon, un constituant permettant de maintenir à un pH fixe une solution dans laquelle il a été ajouté. Il peut s'agir du 2-(N-morpholino) Ethane Sulfonique Acide (ci-après abrégé « MES »), du 2-amino-2-hydroxyméthyl-1, 3-propanediol (ci-après abrégé « Tris »), du 2-(Bis(2-hydroxyethyl)amino)acetique acide (abrégé « Bicine »), de l'acide 4-(2-hydroxyéthyl)-1-pipérazine éthane sulfonique (abrégé « Hepes ») ou du citrate de sodium, de l'acétate de sodium ou encore du cacodylate de sodium.
La solution permettant la mise en œuvre du procédé de cristallisation comprend avantageusement des sels. En effet, Il a été mis en évidence que le transfert des solutés neutres (e.g. PEGs) à travers des membranes en présence de sel est significativement affecté par rapport à leur transfert lorsqu'ils sont seuls en solution (Escoda et al., 2010; Savignac, 2010). Les effets de salting-out et de gonflement de pores doivent être pris en compte dans les procédés de dialyse, car ils sont susceptibles d'affecter l'exclusion stérique des solutés neutres, tels que des PEGs, si des solutions utilisées dans ces procédés contiennent des sels, notamment à des concentrations de sel élevées.
Le réservoir (111) est en communication avec un canal d'entrée et un canal de sortie permettant de faire circuler, avantageusement sous la forme d'un flux continu, une solution permettant la mise en œuvre du procédé de cristallisation. Lorsque la puce (1) comprend plusieurs cellules de cristallisation à dialyse (11), celles-ci peuvent être connectées entre elles et alors les différents réservoirs (111) sont reliés par un même canal principal.
La solution permettant la mise en œuvre du procédé de cristallisation est avantageusement injectée en flux continu à l'aide d'un système de contrôle des écoulements des fluides vers les réservoirs par débit ou pression imposée, une fois que l'assemblage microfluidique complet est réalisé.
La pression d'injection maintenue au niveau du canal microfluidique, au cours du procédé de cristallisation, est avantageusement inférieure à 400 mbar, elle varie avantageusement de 100 à 300 mbar. Si la pression d'injection est supérieure à 400-450 mbar, il y a un risque de déchirement ou de décollement de la membrane de dialyse.
La membrane de dialyse est avantageusement en cellulose (par exemple en cuprophane, à savoir une cellulose régénérée), en cellulose modifiée telle que l'acétate de cellulose, l'hémophane, ou encore en cellulose modifiée synthétiquement.
Une membrane en cellulose présente les propriétés suivantes : finesse, pores de petit diamètre permettant l'élimination de substances de poids moléculaire faible, un faible coût, une forte réactivité chimique (du fait des groupes hydroxyle), une faible biocompatibilité.
La cellulose modifiée présente les propriétés suivantes : une réactivité chimique moindre, une bonne biocompatibilité, une substitution des groupes hydroxyle, une augmentation de la taille des pores, une augmentation de la perméabilité hydraulique, une élimination de substances de plus grand poids moléculaire.
Comme la cellulose régénérée (CR) standard se compose d'un polymère de cellulose naturelle provenant de bourres de coton, ces membranes sont parfaitement adaptées à une large gamme de dialyses de laboratoire. Ce type de membrane transparente et flexible avec une porosité symétrique est économique et résistant; idéal pour le dessalage, les échanges tampon, les purifications macromoléculaires et d'autres applications d'ordre général. Grâce à leur large plage de compatibilité chimique, les membranes CR standard peuvent être utilisées avec des acides et des bases forts

dilués, des acides et des bases faibles concentrés, la plupart des alcools et certains solvants organiques moyens ou dilués, y compris le DMSO. La CR peut être utilisée dans un pH de 2 à 12 et à des températures comprises entre 4°C et 121°C.

Dans le cas des membranes organiques, la structure poreuse résulte des espaces entre les chaînes de polymère. La porosité d'une membrane est définie comme le rapport du volume des espaces vides sur le volume total de la matrice. Cette grandeur dépend de la taille des constituants élémentaires de la matrice mais également du procédé d'élaboration de la membrane. Une membrane poreuse doit posséder une très bonne résistance mécanique tout en permettant un débit de perméation élevé. La séparation dépend des effets stériques (c'est-à-dire d'une discrimination en fonction de la taille de l'espèce à retenir), mais aussi des effets de charges électriques découlant de la nature chimique du matériau membranaire.

Dans le cadre de l'invention, la porosité de la membrane va être choisie en fonction de la taille de molécule à cristalliser. La membrane de dialyse doit permettre un passage de l'agent de cristallisation mais bloquer la molécule à cristalliser.

La membrane est intégrée dans la paroi interne (1113), avantageusement dans la résine NOA81®, avantageusement sans collage chimique. Aux pressions mentionnées ultérieurement, on n'observe pas de fuites ni d'altération des pores de la membrane.

Au sens de l'invention, la périphérie de la membrane est scellée dans une partie d'un seul tenant de la paroi interne ; ce qui signifie que la périphérie de la membrane est insérée dans un seul bloc, avantageusement qui se forme lors de la réticulation de la résine coulée dans le moule. Ce mode de réalisation s'oppose aux modes dans lesquels une membrane est maintenue coincée entre deux blocs distincts, maintenus serrés l'un contre l'autre ou aux modes dans lesquels une membrane est déposée sur un bloc. Dans l'invention, les phases supérieure et inférieure de la périphérie de la membrane sont scellées dans une même partie d'un seul tenant de la paroi interne, c'est-à-dire dans un seul bloc, avantageusement qui se forme lors de la réticulation de la résine coulée dans le moule.

Par « partie d'un seul tenant » on entend ainsi une partie monolithique, c'est-à-dire ne résultant pas du collage ou de l'assemblage de deux parties initialement distinctes.

La chambre de dialyse (113) est destinée à recevoir la molécule à cristalliser, avantageusement sous la forme d'une solution S1. Cette molécule est avantageusement une macromolécule.

On entend aussi dans le cadre de la présente invention par macromolécules, des molécules ayant un poids moléculaire de plusieurs milliers de Daltons à plusieurs centaines de milliers de Daltons. Il peut s'agir de séquences d'acides nucléiques d'ADN ou d'ARN, de fragments de virus, de protéines, de complexes de protéines, de complexes protéine-ARN, de complexes protéine-ligand, ou encore de polypeptides. De plus, la présente invention peut être appliquée avec succès à la cristallisation d'autres types de molécules telles que les particules colloïdales.

Avantageusement, la molécule à cristalliser est choisie parmi des séquences d'acides nucléiques d'ADN ou d'ARN, de fragments de virus, de protéines, en particulier de protéines membranaires, de complexes des protéines, de complexes protéine-ARN, de complexes protéine-ligand, ou encore de polypeptides.

La puce selon l'invention est particulièrement adaptée pour la cristallisation de protéines difficiles à cristalliser telles que les protéines membranaires et les complexes macromoléculaires, ou encore pour des projets pour lesquels l'optimisation de qualité de diffraction du cristal reste difficile.

A titre d'exemple de protéine cristallisée dans le cadre de l'invention, on peut citer le lysozyme du blanc d'œuf de poule.

A titre d'exemple, le lysozyme est solubilisé dans un tampon : l'acétate de sodium, à concentration de 100 mM. Cela permet de maintenir un pH de la solution à 4. La concentration du lysozyme est de 30mg/mL. La solution permettant la mise en œuvre du procédé de cristallisation est une solution comprenant 0,9M NaCl, et 100mM de tampon Na acétate de pH 4.

Après dépôt de la solution de molécule à cristalliser, la chambre de dialyse (113) est avantageusement scellée par une couche de polymère transparent au RX, avantageusement de PMMA.

L'espace entre les parois externes (1112) et internes (1113), débouchant sur une surface principale (1114) de la puce, est avantageusement connecté via un raccord, situé en surface de la puce, au système de contrôle des écoulements des fluides (1116). Par ce connecteur pourra être injectée dans la puce la solution des agents de cristallisation. Ce raccord peut être en élastomère ou métallique (e.g. une aiguille). Cette surface ne sera pas analysée par RX, et il est donc possible d'utiliser un matériau non transparent aux RX.

Afin de protéger les chambres de dialyse, il est possible, après avoir introduit la solution comprenant la macromolécule à cristalliser, avantageusement d'avoir déposé une couche de PMMA, de déposer une couche supplémentaire (1116) adhésive, par exemple en Kapton®. Cette couche adhésive Kapton® permet d'assurer l'étanchéité à l'air des chambres de dialyse.

Le Kapton® est un film de polyimide (polymère à base d'imide) développé par DuPont qui peut rester stable dans une plage étendue de température :

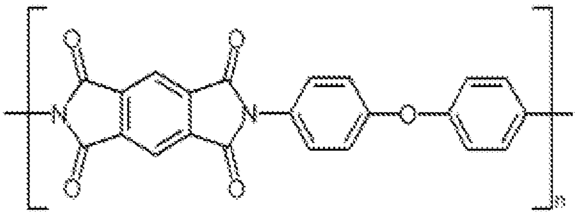

Le volume de la chambre de dialyse est avantageusement compris entre 0,1 et 1 μL.

Le volume du réservoir est le même que celui de la chambre de dialyse. Avantageusement, son contenu est renouvelé grâce au flux continu pour atteindre un volume centaines voire milliers de fois supérieur et pour améliorer le procédé de dialyse.

De par l'emploi de l'expression « est compris de X à XX », les bornes, X et XX, sont incluses.

Selon une variante avantageuse de l'invention, la puce microfluidique comprend plusieurs cellules de cristallisation à dialyse alignées en lignes et colonnes.

On peut ainsi envisager de faire varier, d'une ligne à l'autre, la concentration en agent de cristallisation et/ou additifs dans la solution de précipitation et de faire varier, d'une colonne à l'autre, la température. On pourra ainsi analyser l'effet de la température, à concentration constante, ou l'effet de la concentration, à température constante, ou l'effet combiné d'une variation de température et de concentration.

Pour permettre de faire varier la température d'une cellule à l'autre, le dispositif de cristallisation comprend, outre la puce microfluidique (1), un système de contrôle de température, permettant de contrôler la température et de la faire varier ; en particulier d'appliquer une température constante différente d'une colonne à l'autre. Dans un mode de réalisation de l'invention, le système de contrôle de la température est basé sur la technologie Peltier. Il peut s'agir d'une Cellule à Effet Peltier (CEP), appelée aussi module thermoélectrique. Un tel exemple est représenté sur la figure 5.

L'invention a également pour objet un procédé de préparation d'une puce microfluidique (1) selon l'invention, caractérisé en ce qu'il comprend les étapes successives suivantes :

- Réaliser deux blocs structurés PDMS pour obtenir les tampons 3D en PDMS de la partie haute qui définira la chambre de dialyse et de la partie basse de la puce qui définira les canaux et le(s) réservoir(s),
- Sur le bloc de PDMS avec les canaux et le(s) réservoir(s) déposer une ou plusieurs membrane(s) de dialyse sèche(s),
- Placer le bloc de PDMS structuré sans canaux en coïncidence avec le bloc de PDMS avec les canaux de manière à prendre en sandwich la membrane,
- Déposer la NOA81® sur 3 côtés entre les deux blocs de PDMS,
- Initier la réticulation de la NOA81®,
- Retirer la partie supérieure en PDMS avec l'assemblage en NOA81® en décollant le tout du bloc du PDMS du bas,
- Refermer la partie visible (sans PDMS) avec une lamelle de PMMA,
- Finaliser la réticulation de la NOA81®,
- Retirer le dernier bloc de PDMS

L'étape d'initiation de la réticulation de la NOA81® doit permettre de polymériser suffisamment la NOA81® pour obtenir un matériau manipulable tout en la durcissant au minimum. En effet, la réticulation doit être la plus faible possible afin de permettre un collage de la membrane et une bonne cohésion de la membrane dans la résine. Le procédé se caractérise en ce que la membrane est intégrée dans la résine. On peut ainsi parler de collage non chimique. L'ajout ultérieur de la lamelle de PMMA suivi d'un temps de réticulation supplémentaire de la résine vient aider au collage de la membrane.

Le poly(dimethylsiloxane), aussi appelé PDMS, est un polymère qui se présente sous la forme d'un liquide visqueux et transparent à l'œil. Sa formule chimique est représentée ci-dessous :

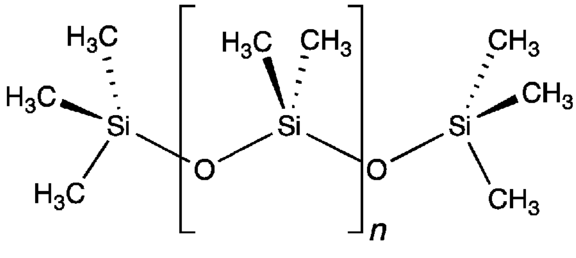

Une fois réticulé (solidifié), il a la particularité d'être perméable à l'air et d'être suffisamment élastique.

Il existe deux types de PDMS, le PDMS RTV-615 et le PDMS Sylgard 184 de Dow Corning. Dans les deux cas il est nécessaire de le mélanger à un agent réticulant puis de le chauffer pour activer la réticulation du matériau. Le mélange se fait généralement dans les proportions massiques 1:10 (agent réticulant:PDMS), ce ratio peut toutefois varier en fonction de l'utilisation du PDMS.

L'invention a également pour objet un dispositif de cristallisation d'une molécule à cristalliser qui comprend

- Au moins une puce microfluidique selon l'invention
- Au moins un moyen d'ajout agencé pour ajouter dans la chambre de dialyse une solution S1 comprenant la molécule à cristalliser et éventuellement au moins un tampon (puis finalisation de la puce par encapsulation des chambres de dialyse, tel que décrit précédemment)
- Eventuellement au moins un moyen de contrôle et de variation de la température de la puce microfluidique selon l'invention
- Eventuellement au moins un moyen d'ajout / prélèvement agencé d'agent de cristallisation et/ou d'additif(s) et/ou tampon(s) (et ainsi de la composition chimique de la solution permettant la mise en œuvre du procédé de cristallisation dans les canaux menant à la chambre du réservoir)
- Eventuellement au moins un moyen de contrôle de la composition chimique de la solution dans le réservoir, par exemple un moyen de dosage, de variation de la concentration des tampons, des agents de cristallisation et des additifs
- Au moins un moyen d'acquisition d'images

Grâce au moyen d'ajout et/ou au moyen de prélèvement, la nature des constituants que contient la solution injectée dans le réservoir (les agents de cristallisation, les additifs, les tampons) ainsi que la concentration de ces constituants peut varier au cours de la cristallisation. La composition de la solution injectée dans le réservoir peut être ajustée précisément par l'opérateur qui réalise la cristallisation. Pour décider des variations de la composition de la solution injectée dans le réservoir, l'opérateur s'en réfère notamment à des concepts physico-chimiques déterminés d'après les diagrammes de phases de la molécule à cristalliser.

La solution permettant la mise en œuvre du procédé de cristallisation est avantageusement injectée en flux continu à l'aide d'un système de contrôle des écoulements des fluides vers les réservoirs par débit ou pression imposée, une fois que l'assemblage microfluidique complet est réalisé.

Grâce au dispositif de cristallisation selon l'invention, une optimisation de la nucléation et de la croissance cristalline peut être obtenue en combinant une méthode de dialyse avec des variations précises de la température et de la composition de la solution injectée dans le réservoir qui sont décidées par l'opérateur à partir de contrôles des paramètres de la cristallisation (la température, la concentration de la molécule à cristalliser et la composition de la solution injectée dans le réservoir) effectués au cours de la cristallisation.

L'invention permet ainsi d'offrir une plate-forme pour la cristallisation unique, permettant un contrôle précis de tous les paramètres et leur automatisation, favorisant un processus de miniaturisation par la technologie microfluidique. Sa réalisation apporte d'importantes réductions du coût de la détermination de la structure tridimensionnelle des macromolécules biologiques, étant une étape cruciale dans l'approche multi-échelle des processus biologiques.

Préalablement à la mise en œuvre du procédé de cristallisation, il est possible de conditionner la puce microfluidique selon l'invention. Par exemple, il est possible de déposer la puce exempte de tout liquide dans un plasma pour la nettoyer : dépression (en utilisant par exemple une pompe à vide), pour évacuer l'air de la chambre puis une fois atteinte la pression recherchée (dans le cadre de l'invention, une dépression à 0,7 mbar est adaptée) la bobine électrique crée le plasma. Le plasma est un gaz partiellement ionisé composé d'électrons, des ions et des atomes ou molécules neutres. Le plasma crée des espèces réactives à la surface de certains matériaux (e.g. verre et PDMS) qui, lorsque mis ensemble peuvent former une liaison permanente. Dans le cadre de l'invention, le plasma va transformer les surfaces des membranes pour faciliter le mouillage hydrophile, ce qui facilite l'ajout de liquides. De plus, le plasma stérilise les dispositifs microfluidiques. La puce pourra par exemple être traitée au plasma pendant 1 minute.

Ce conditionnement préalable de la puce permet d'augmenter la mouillabilité de la surface de la membrane et de garantir une bonne adhésion avec la solution de molécule à cristalliser.

L'invention concerne également un procédé de cristallisation d'une molécule à cristalliser, caractérisé en ce qu'il comprend les étapes successives suivantes :

a) On ajoute une solution S1 comprenant la molécule à cristalliser dans la chambre de dialyse (113) de la puce microfluidique (1) selon l'invention puis avantageusement on ferme la chambre de dialyse (113).

b) Le cas échéant, on injecte en continu une solution S2 dans les canaux de ladite puce microfluidique (1), ladite solution S2 contenant uniquement le tampon, la pression d'injection au niveau du canal microfluidique est maintenue inférieure à 400 mbar.

c) On injecte en continu une solution S3 de cristallisation, dans les canaux de ladite puce microfluidique (1), la

pression d'injection au niveau du canal microfluidique est maintenue inférieure à 400 mbar.

La solution S3 de cristallisation contient au moins un agent de cristallisation et le cas échéant un ou plusieurs additifs, et éventuellement un tampon. Lorsque l'étape b) du procédé est mise en œuvre, la solution S3 comprend le tampon de la solution S2 et au moins un agent de cristallisation et le cas échéant un ou plusieurs additifs.

Lors de l'étape b), le tampon présent dans la solution S2 diffuse dans la solution contenue dans la chambre de dialyse

Préalablement à l'étape b), le tampon est choisi en fonction de la molécule à cristalliser, en prenant en particulier en considération les paramètres de solubilité. Lors de l'étape a) la chambre de dialyse (113) est avantageusement fermée par encapsulation, c'est-à-dire par dépôt d'une couche (1115) telle qu'une lamelle de PMMA.

Suite à l'étape a), et avantageusement avant l'injection d'une solution dans le réservoir, la chambre de dialyse (113), et avantageusement la couche de PMMA (1115), est avantageusement recouverte d'une couche d'adhésif de KAPTON® (1116).

Au cours du procédé, la composition de la solution injectée dans le réservoir de la cellule de cristallisation peut commodément varier (ou autrement dit être ajustée) en fonction des quantités requises en agents de cristallisation, le cas échéant en additifs, éventuellement en tampons au fur et à mesure du procédé. Elle peut donc évoluer au cours de la cristallisation, et ce de manière réversible, du fait de la diffusion au travers de la membrane de dialyse des constituants de la solution injectée.

Le procédé selon l'invention permet de faire varier la concentration en précipitant dans la solution de concentration ou la température dans chaque cellule de cristallisation à dialyse (11). Selon une première variante du procédé de cristallisation, dans le cas d'un système protéique avec la solubilité directe (solubilité de la protéine augmentant avec la température) :

- Lors de l'étape a), le cas échéant lors de l'étape b), la solution contenue dans la chambre de dialyse est à une température constante T de la cellule de cristallisation (11) et à une concentration C1 de la molécule à cristalliser de telle sorte que la molécule à cristalliser se trouve dans la zone de sous-saturation (en dessous de la courbe de solubilité) du diagramme de phases de ladite molécule à cristalliser établi en fonction des paramètres de la concentration de la molécule à cristalliser et de la concentration en agent de cristallisation et le cas échéant d'un ou de plusieurs additifs ; lors de l'étape b), le tampon présent dans la solution S2 diffuse dans la solution contenue dans la chambre de dialyse et la molécule à cristalliser se trouve toujours dans ladite zone de sous-saturation
- Lors de l'étape c), ladite solution de cristallisation S3 contient, le cas échéant en plus du tampon, au moins un agent de cristallisation et le cas échéant un ou plusieurs additifs à une concentration P constante, de manière à ce que l'agent de cristallisation et le cas échéant l'additif diffuse dans la solution contenue dans la chambre de dialyse et de telle sorte que la molécule à cristalliser se trouve dans la zone de nucléation spontanée ou sur la limite supérieure de la zone métastable du diagramme de phases de ladite molécule à cristalliser et qu'apparaissent des germes de la molécule à cristalliser ;

Et le procédé comprend ensuite les étapes successives suivantes :

d) on augmente la température de la cellule de cristallisation (11) à une température T2 de telle sorte que la nucléation est arrêtée et que la molécule à cristalliser se trouve dans la zone métastable du diagramme de phases de la molécule à cristalliser,

e) s'il y a la formation de trop nombreux cristaux pendant l'étape c), la température de la cellule de cristallisation (11) peut-être augmentée à une température >T2 de telle manière que la molécule à cristalliser se retrouve dans la zone de sous-saturation, juste en dessous de la courbe de solubilité, à nouveau et que l'excès de petits cristaux soient complètement dissout. Quelques cristaux sélectionnés, de tailles supérieures vont subir une dissolution partielle en évitant la dissolution complète et vont ensuite croitre dans la zone métastable par la baisse de température à la température T2

f) On laisse grossir les germes de cristaux à la température T2 jusqu'à l'obtention d'un premier point d'équilibre E1, où la taille des cristaux demeure constante, la concentration de la molécule à cristalliser dans la solution contenue dans la chambre de dialyse atteinte étant alors la concentration C2,

g) On abaisse la température de la cellule de cristallisation (11) à une température T3, de telle sorte que les cristaux présents dans la chambre de dialyse (113) se situent toujours dans la zone métastable du diagramme de phases de la molécule à cristalliser

h) On laisse grossir les germes de cristaux et les cristaux à la température T3 jusqu'à l'obtention d'un deuxième point d'équilibre E2 où la taille des cristaux demeure constante, la concentration de la molécule à cristalliser dans la solution contenue dans la chambre de dialyse atteinte étant alors la concentration C3

i) On répète éventuellement les étapes f) à h)

j) On récupère la puce contenant les cristaux obtenus à l'issue de l'étape h) ou i) pour l'expérience de diffraction aux rayons X *in situ.*

Selon une deuxième variante du procédé de cristallisation :

- Lors de l'étape a), le cas échéant lors de l'étape b), la solution contenue dans la chambre de dialyse est à une température constante T de la cellule de cristallisation (11) et à une concentration C1 de la molécule à cristalliser de telle sorte que la molécule à cristalliser se trouve dans la zone de sous-saturation (en dessous de la courbe de solubilité) du diagramme de phases de ladite molécule à cristalliser établi en fonction des paramètres de la concentration de la molécule à cristalliser et de la concentration en agent de cristallisation et le cas échéant en additif ; lors de l'étape b), le tampon présent dans la solution S2 diffuse dans la solution contenue dans la chambre de dialyse et la molécule à cristalliser se trouve toujours dans ladite zone de sous-saturation
- Lors de l'étape c), ladite solution de cristallisation S3 contient, le cas échéant en plus du tampon, au moins un agent de cristallisation et le cas échéant un ou plusieurs additifs à une concentration P1 dans le réservoir de la cellule de cristallisation, de manière à ce que l'agent de cristallisation et le cas échéant l'additif diffuse dans la solution contenue dans la chambre de dialyse et de telle sorte que la molécule à cristalliser se trouve dans la zone de nucléation spontanée ou sur la limite supérieure de la zone métastable du diagramme de phases de ladite molécule à cristalliser et qu'apparaissent des germes de la molécule à cristalliser ;
- Pour obtenir la nucléation spontanée contrôlée des cristaux la procédure suivante est employée : à l'aide du système de contrôle des écoulements des fluides la solution de cristallisation S3 est injectée en flux continu avec un gradient de concentration de l'agent de cristallisation et le cas échéant d'additif de manière à ce que à la concentration P1 seulement quelques cristaux se forment.

et le procédé comprend ensuite les étapes successives suivantes :

d) On diminue la concentration de l'agent de cristallisation et le cas échéant de l'additif à une concentration P2, de telle sorte que la nucléation est arrêtée et que la molécule à cristalliser se trouve dans la zone métastable dudit diagramme de phases de la molécule à cristalliser

e) On laisse grossir les germes de cristaux à la concentration P2 de l'agent de cristallisation et le cas échéant de l'additif jusqu'à l'obtention d'un premier point d'équilibre E1, où la taille des cristaux demeure constante, la concentration de la molécule à cristalliser dans la solution contenue dans la chambre de dialyse atteinte étant alors la concentration C2

f) On augmente la concentration de l'agent de cristallisation et le cas échéant de l'additif à une concentration P3, de telle sorte que les cristaux présents dans la cellule de cristallisation (11) se situent toujours dans la zone métastable dudit diagramme de phases de la molécule à cristalliser,

g) On laisse grossir les germes de cristaux et les cristaux à la concentration P3 de l'agent de cristallisation et le cas échéant de l'additif jusqu'à l'obtention d'un deuxième point d'équilibre E2 où la taille des cristaux demeure constante, la concentration de la molécule à cristalliser dans la solution contenue dans la chambre de dialyse atteinte est la concentration C3,

h) On répète éventuellement les étapes d) à f)

i) On récupère la puce contenant les cristaux obtenus à l'issue de l'étape g) ou h) pour l'expérience de diffraction aux rayons X *in situ.*

Ces procédés pourraient être utilisés en parallèle sur la puce (1), dans des cellules de cristallisations (11) différentes contenues dans la puce.

Les exemples qui suivent illustrent l'invention sans la limiter.

**EXEMPLES**

Les méthodologies suivantes ont été utilisées :

**<u>Conception de moule SU8 :</u>**

Ici est expliqué un protocole pour réaliser un moule en SU8 à deux niveaux. Ce moule servira ensuite à la préparation des blocs structurés en PDMS.

Design d'un masque pour la lithographie :

Pour réaliser un moule en SU8 il est nécessaire de disposer d'un ou plusieurs masques qui serviront à définir le motif du moule. Pour cela le logiciel CleWin3 a été utilisé. Il permet de concevoir des réseaux de canaux qui peuvent être imprimés sur feuille transparente en négatif ou en original. Si plusieurs masques sont créés pour une même puce il est possible de réaliser un moule à plusieurs couches.

Une technique pour aligner les masques facilement peut-être utilisée sous clewin en dessinant des carrés sur un niveau et des carrés plus petits sur un autre niveau, ainsi lors de l'alignement il suffit de superposer les carrés

SU-8 :

La SU8 est une résine photosensible négative qui est un polymère se présentant sous la forme d'un liquide visqueux. Pour déclencher le processus de réticulation il faut l'exposer aux UV puis le chauffer. Après chauffage il faut le développer dans un bain de PGMEA. Toutes les parties insolées se seront solidifiées, les parties non exposées disparaîtront avec le développement. Sa formule chimique est représentée ci-dessous :

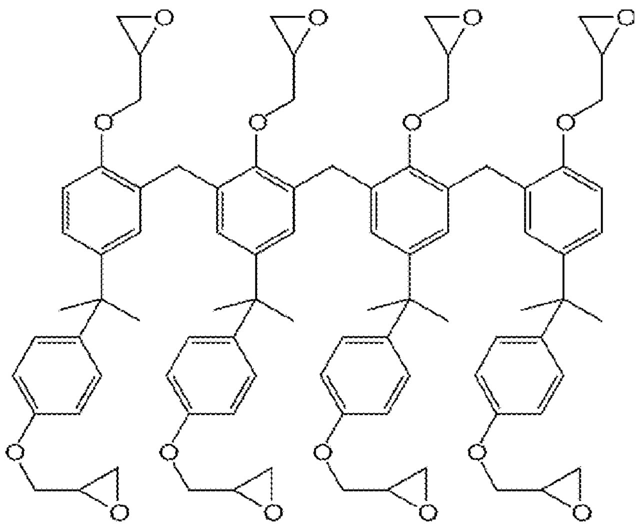

La SU8 existe sous différentes séries, parmi elles il y a notamment les séries SU8-20XX et SU8-30XX. La résine est étalée sur une tournette avant exposition. En fonction de la résine choisie et de l'épaisseur de SU8 désiré il existe différents programmes donnés par le fabricant. Cette résine sert généralement dans la conception de moule mais peut aussi être utilisé pour réaliser des puces complètes.

Conception du moule :

En premier lieu il faut sortir la SU8 3000 du réfrigérateur à l'avance, de préférence entre 1 à 2h de manière à ce qu'elle soit à température ambiante.

La première étape, qui est assez récurrente, est de nettoyer un wafer de silicium à l'aide d'isopropanol, acétone puis isopropanol à nouveau. Il faut ensuite activer la surface du wafer au plasma pour augmenter la mouillabilité de la surface et garantir une bonne adhésion avec la SU8. Pour cela il faut déposer le wafer dans le plasma 45sec en High Exposure. Mettre le vide jusqu'à 500mTorr. Faire entrer un peu d'azote afin que le vide oscille entre 500mTorr et 1000mTorr.

Déposer le wafer sur la tournette (SPIN 150) et le centrer. Disposer 1mL de SU8 et ajuster le SPIN 150 de manière à obtenir la hauteur voulue (cf. Protocole Microchem SU-8 3000).

Récupérer le wafer + SU8 et le mettre à chauffer (« Soft Bake », cf. Protocole Microchem SU-8 3000). Le temps dépend de l'épaisseur. Il faut savoir qu'avec les résines SU8 2000 un palier de température à 65°C était nécessaire afin d'éviter le craquement de la résine. Dans le cadre de la SU8 3000 ce palier n'est pas nécessaire. Toutefois pour tous les chauffages on évite de déposer directement la résine à la température maximum. On se place donc au dessus de la plaque chauffante à 1-2cm et on attend 1 minute avant de déposer complètement le wafer sur la plaque à température finale. Attendre le refroidissement (5-15min).

Scotcher le 1er masque sur une plaque de verre (en dessous) de manière à avoir les écritures dans le bon sens au dessus sur l'aligneur.

Mettre la plaque dans l'exposeur aux UV et déposer le wafer sous cette plaque.

Il faut dans un premier temps diminuer le WEC (Wedge Error Compensation) puis monter le wafer à l'aide d'un levier dédié. La suite concerne l'ajustement du WEC. Ajuster le WEC dans le programme « Settings » → « WEC settings ». Monter la plaque en utilisant le bouton du WEC jusqu'à ce que le réglage soit complet.

Choisir ensuite « Align and expose » avec l'option « Soft Contact » et le temps d'exposition en fonction du protocole (cf. Protocole Microchem SU-8 3000). Pour ce faire il faut multiplier la puissance par $cm^2$ de la lampe par le temps d'exposition pour connaître l'énergie par $cm^2$ que l'on dépose. Exemple pour obtenir $350mJ/cm^2$ avec une puissance de $35mW/cm^2$ on applique un temps de 10 secondes : $35mW/cm^2$ x 10s = $350mJ/cm^2$.

Récupérer le wafer pour le « Post exposure bake ». Temps indiqué sur le protocole (cf. Protocole Microchem SU-8 3000). On observe l'apparition du motif dès 15sec de chauffage.

L'étape suivante consiste à recommencer toutes les étapes depuis le début sur la nouvelle couche de SU8 (en ayant laissé un peu reposer après le chauffage).

Une fois arrivé à l'étape de l'exposition aux UV il y a des modifications :
Aligner les masques, pour cela placer grossièrement le second masque au mieux comme celui d'avant. Abaisser « un peu » le WEC pour que le bloc de SU8 ne colle pas au masque. Descendre le microscope (il devrait y avoir écrit : microscope is down). Aligner le microscope de gauche et de droite en jouant sur : la focale globale, les 2 focales indépendantes de chaque microscope, la position x et y, la position x indépendante de chaque microscope, la rotation des 2 microscopes selon z.

Une fois ce réglage fait, monter le wafer et observer les motifs dans la SU8 à travers le nouveau masque. L'objectif étant d'utiliser l'astuce de dessin sous CleWin3 en superposant les marques d'alignement.

Remonter le WEC par la même procédure que précédemment.

Exposer le temps adéquat, chauffer « Post exposure bake » et développer dans du PGMEA (Attention bien travailler sous hotte !) (cf. Protocole Microchem SU-8 3000).

Attention : il ne faut pas trop développer sinon il peut y avoir un décollement de la SU8, mais il faut suffisamment développer tout de même pour qu'il n'y ait pas de traces blanches. Pour arrêter le processus, sortir le wafer du bain et appliquer « abondamment » de l'isopropanol. Sécher à l'azote.

Analyse des lithographies :

Les épaisseurs des lithographies ont été analysées avec un profilomètre Dektak. L'appareil possède 2 dynamiques maximum susceptible de nous intéresser: 65μm ou 252μm. Il faut alors choisir la longueur à analyser, le temps d'analyse, et le type de profil de surface envisagé « collines » ou « vallées ».

**Exemple 1 : Micropuce selon l'invention**

Un design a été réalisé permettant l'utilisation en parallèle de plusieurs conditions et d'envisager des tests avec gradient de température.

La solution permettant la mise en œuvre du procédé de cristallisation est introduite dans les canaux et la protéine est déposée dans le réservoir directement « par dessus » la puce.

Dans cette puce, on ne cherche pas à encapsuler la protéine mais on cherche à faire couler la solution permettant la mise en œuvre du procédé de cristallisation en continu au détriment de l'encapsulation de la protéine qui se retrouve dorénavant déposée à la main ou avec l'assistance d'un robot. Pour éviter toute évaporation à partir de la solution de protéine, la chambre de dialyse est avantageusement enfermée par encapsulation rapidement, c'est-à-dire par dépôt d'une couche de PMMA recouverte d'une couche d'adhésif de KAPTON®, ou toute la procédure de remplissage de la puce doit être effectuée dans une enceinte avec atmosphère contrôlée (taux de l'humidité et température).

Un protocole de préparation d'une puce selon l'invention est décrit ci-après :
Tout d'abord on réalise deux blocs structurés en PDMS. Ces blocs peuvent être préparés par des procédés classiques. A titre d'illustration, le procédé suivant pourra être utilisé.

Procédé de préparation des blocs structurés en PDMS :

Il existe 2 types de PDMS de caractéristiques similaires : le Sylgard 184 de Dow Corning et le RTV 615 de Bayer Silicones.

Mélanger un ratio 10:1 en masse de PDMS:agent réticulant (généralement pour une boîte de pétri 20g:2g)

Agiter le mélange avec une baguette de manière à homogénéiser et former des bulles. Placer le tout sous cloche à vide jusqu'à dégazage complet. Faire monter les bulles puis attendre 10-20 min. Remettre un vide plus poussé et dégazer au fur et à mesure. Enfin attendre que les bulles disparaissent.

Couler le PDMS dans le moule

Laisser à l'étuve 1h environ.

Le moule est le moule SU8 dont le procédé de préparation est décrit en préambule des exemples.

On réalise deux blocs de PDMS pour obtenir les tampons 3D en PDMS de la partie haute et de la partie basse de la puce.

Poser sur une lame de verre le bloc avec les canaux.

Sur le bloc de PDMS avec les canaux, déposer une membrane de dialyse sèche (ou plusieurs en fonction de la géométrie). Le volume de la chambre de dialyse est 0,7$\mu$L, la hauteur du canal est 100$\mu$m, la largeur du canal est de 500$\mu$m.

Le bloc de PDMS sur lequel se trouve la membrane doit être plus grand que le bloc qui va s'appuyer sur lui.

Placer le bloc sans canaux en coïncidence avec le bloc à canaux de manière à prendre en sandwich la membrane.

Mettre le tout sous la cloche à vide pendant 30 minutes.

Récupérer le tout et déposer ensuite la NOA81® sur 3 côtés dans l'espacement entre les 2 blocs de PDMS.

Laisser la NOA81® remplir l'espace par capillarité.

Une fois l'espace rempli (quelques minutes), déposer le tout sous la lampe UV.

Faire un Flood Exposure, 6 sec (lampe 35mW/cm$^2$, lambda 385nm) (soit 210mJ/cm$^2$ d'exposition).

Découper les bourrelés de NOA81®.

Retirer la partie supérieure en PDMS avec l'assemblage en NOA81® en décollant le tout du bloc du PDMS du bas.

Refermer la partie « visible » (sans PDMS) avec une lamelle PMMA en chassant les bulles progressivement. Attention cette étape peut être longue car il faut être très patient pour ne pas capturer de bulles.

Flood Exposure, 60 sec (mêmes conditions de lampe).

Retirer le dernier bloc de PDMS.

Nettoyer ensuite les tampons en appliquant abondamment à la pissette de l'isopropanol, de l'acétone puis de l'isopropanol à nouveau. Utiliser du scotch pour retirer les éventuelles traces restantes.

Lors de l'étape où l'on dépose la membrane il faut faire coïncider les deux blocs de PDMS. Cependant en pratique il est très difficile voire impossible de les faire coïncider parfaitement et ceci d'autant plus que le motif de la puce se complexifie. Pour cette raison les deux blocs sont alignés d'abord à l'oeil puis au microscope optique. Toutefois il subsiste toujours un décalage non préjudiciable entre les deux parties.

**Exemple comparatif 1 : Micropuce avec une membrane non intégrée dans la hauteur des parois internes**

Dans cette méthode, on utilise un seul bloc de PDMS structuré, celui permettant de définir les canaux et le(s) réservoir(s).

Au préalable il faut avoir préparé sa lithographie et y avoir déposé du PDMS réticulé. Un deuxième bloc de PDMS coulé sur un wafer nu est nécessaire.

Découper le PDMS du wafer moulé et un bloc de PDMS « plat » plus large que le bloc avec motif. Déposer une membrane de dialyse par dessus faisant approximativement la taille du réservoir central sur le bloc de PDMS plat, lui même posé sur une lame de verre. Mettre le bloc de PDMS avec motif par dessus en faisant coïncider le trou central et la membrane. Laisser dégazer pendant 30min pour faciliter l'étape d'après.

Introduire la NOA81 sur 3 des bords de la puce pour la faire entrer par capillarité. Insoler ensuite 6 sec en « flood exposure ». Récupérer le tout et décoller le bloc de PDMS du dessus (celui avec les motifs). Découper les bourrelés de NOA81. Mettre une lame de verre par dessus et exposer le tout 60 sec en « flood exposure ». Décoller la lame de verre du PDMS. On obtient un système comme représenté sur la Fig 3.

Ce système n'est toutefois pas satisfaisant car on a observé que la membrane ne résistait pas (se décollait) lorsque l'on fait couler du liquide dans la puce.

**Exemple comparatif 2 : Micropuce avec encapsulation des molécules à cristalliser**

Pour répondre à tous les objectifs énoncés plus avant, un premier design, consistant à utiliser les propriétés d'écoulement dans les canaux et en particulier l'augmentation de la résistance hydrodynamique lorsque la dimension du canal diminue, a été conçu.

Cette puce est donc différente dans le sens où on cherche à encapsuler la protéine afin de la protéger, notamment pour éviter toute évaporation.

La puce est réalisée avec deux niveaux, il est donc nécessaire d'avoir 2 masques. Les canaux ont des dimensions de 0,5mm de large avec une longueur de canal du trou d'entrée au réservoir central d'environ 18,6mm. Le canal

alimentant le réservoir central a une largeur de 0,4mm et une longueur de 0,1mm. Le réservoir central fait 3mm de diamètre. Deux lithographies différentes ont été réalisées, la première possède une hauteur de SU8 de 50μm par couche soit un total de 100μm, la deuxième 25μm par couche pour une épaisseur totale de 50μm.

Ce design a été choisi avec pour objectif de délivrer la protéine selon le schéma de la Fig 4.

Dans un premier temps il faut remplir le réservoir de protéine. Pour cela on obture deux entrées diagonalement opposées et on introduit le liquide. Une fois le réservoir rempli on obture deux entrées situées du même côté et on injecte de l'huile de paraffine pour « fermer » un côté de la puce. On réitère le processus pour l'autre côté de la puce. Au final on devrait se retrouver avec une goutte de protéine encapsulée dans le réservoir central.

On sait d'après la théorie que la résistance hydrodynamique, dans le cas de canaux rectangulaires, est proportionnelle à l'inverse du produit largeur par hauteur au cube. On a donc :

$$R \propto \omega \cdot h^3$$

avec ω largeur du canal en μm
h hauteur du canal en μm

Si on fait un calcul qualitatif ne prenant en compte que ces paramètres on peut calculer le rapport de résistance entre le canal d'entrée de la solution Rsol et le canal d'entrée dans le réservoir Rres. En assumant une hauteur de 100μm et en reprenant les largeurs précédemment citées pour cette puce, on obtient alors :

$$\frac{R_{res}}{R_{sol}} \sim 1.25$$

Ce rapport pourrait être grandement augmenté en diminuant la hauteur de la puce au niveau du canal du réservoir mais cela complique fortement la fabrication.

En pratique nous avons obtenu des résultats différents. Tout d'abord le réservoir de protéine ne se remplit pas sans capturer de bulles, une fois ces bulles formées il devient quasiment impossible de les faire partir du réservoir.

De plus le remplissage d'un seul canal comme sur le schéma Fig 4.B n'est pas possible dû à la compressibilité de l'air. Tous les canaux vont donc se remplir avec toutefois une préférence pour les canaux non bouchés.

Enfin lors de l'étape de fermeture, les lignes de courants de l'huile de paraffine passent par le réservoir central et remplacent la solution de protéine (solution de colorant dans notre schéma) par l'huile. Cet effet peut être interprété en terme de mouillage. En effet en déposant une goutte d'eau et une goutte d'huile à la surface d'une puce en NOA81® on observe clairement que l'angle de contact θ(huile) est plus faible que l'angle de contact θ(eau). Ceci se traduit par une meilleure affinité de l'huile par rapport à la NOA81® que l'eau. De cette manière l'huile aura toujours préférence à épouser au maximum la NOA81® par rapport à l'eau et va donc chasser l'eau du réservoir central.

## Revendications

1. Puce microfluidique (1) comprenant au moins une cellule (11) de cristallisation à dialyse, ladite cellule (11) comprenant :

   - un support (1111) en PMMA,
   - un premier étage comprenant un réservoir (111) délimité au moins en partie par ledit support (1111) et par une paroi externe (1112) de la cellule, ledit réservoir (111) étant en communication fluidique avec un canal d'entrée et un canal de sortie d'une solution permettant la mise en œuvre du procédé de cristallisation,
   - un second étage comprenant une chambre de dialyse (113) délimitée au moins en partie par une paroi interne (1113) de la cellule sans contact avec le support (1111) et par une membrane de dialyse (112) formant une interface entre le réservoir (111) et la chambre de dialyse (113), la paroi interne (1113) comprenant au moins une portion d'un seul tenant dans laquelle la périphérie de ladite membrane (112) est maintenue scellée.

2. Puce microfluidique (1) selon la revendication 1, **caractérisée en ce que** la chambre de dialyse contient une solution de molécule à cristalliser et **en ce que** la chambre de dialyse est scellée par une couche de polymère en PMMA (1115).

3. Puce microfluidique (1) selon l'une quelconque des revendications précédentes, **caractérisée en ce qu'**il existe

un espace entre les parois externes (1112) et internes (1113) débouchant sur une surface principale (1114) de la puce et **en ce que** cet espace, en surface de la puce, est connecté via un raccord au système de contrôle des écoulements des fluides (1116).

**4.** Puce microfluidique (1) selon l'une quelconque des revendications précédentes, **caractérisée en ce que** la membrane de dialyse est en cellulose, avantageusement en cellulose regénérée.

**5.** Puce microfluidique (1) selon la revendication 1, **caractérisée en ce que** le volume de la chambre de dialyse est compris entre 0,1 et 1 μL.

**6.** Puce microfluidique (1) selon l'une quelconque des revendications précédentes, **caractérisée en ce qu'**elle comprend plusieurs cellules de cristallisation à dialyse alignées en lignes et colonnes.

**7.** Procédé de préparation d'une puce microfluidique (1) selon l'une quelconque des revendications précédentes, **caractérisé en ce qu'**il comprend les étapes successives suivantes :

- Réaliser deux blocs structurés en polymère réticulé perméable à l'air PL pour obtenir les tampons 3D en ledit polymère PL de la partie haute qui définira la chambre de dialyse et de la partie basse de la puce qui définira les canaux et le(s) réservoir(s),
- Sur le bloc structuré avec les canaux et le(s) réservoir(s) déposer une ou plusieurs membrane(s) de dialyse sèche(s),
- Placer le bloc structuré sans canaux en coïncidence avec le bloc structuré avec les canaux de manière à prendre en sandwich la membrane,
- Déposer une résine photosensible NOA81® sur 3 côtés entre les deux blocs structurés puis initier la réticulation de ladite résine NOA81®,
- Retirer la partie supérieure du bloc structuré avec l'assemblage en résine réticulée en décollant le tout du bloc structuré du bas,
- Refermer la partie visible (sans PL) avec une lamelle de PMMA,
- Finaliser la réticulation de ladite résine NOA81®,
- Retirer le dernier bloc structuré

**8.** Dispositif de cristallisation d'une molécule à cristalliser qui comprend

- Au moins une puce microfluidique selon l'une quelconque des revendications 1 à 6,
- Au moins un moyen d'ajout agencé pour ajouter dans la chambre de dialyse une solution S1 comprenant la molécule à cristalliser et éventuellement au moins un tampon,
- Au moins un moyen d'ajout / prélèvement agencé d'agent de cristallisation et/ou d'additif(s) et/ou tampon(s) dans les canaux menant à la chambre du réservoir,
- Au moins un moyen de contrôle de la composition chimique de la solution dans le réservoir, par exemple un moyen de dosage, de variation de la concentration des tampons, des agents de cristallisation et des additifs,
- Au moins un moyen de contrôle et de variation de la température de la puce microfluidique selon l'une quelconque des revendications 1 à 6,
- Eventuellement au moins un moyen de mesure de la concentration de la molécule à cristalliser dans la solution S1,
- Au moins un moyen d'acquisition d'images.

**9.** Procédé de cristallisation d'une molécule à cristalliser, **caractérisé en ce qu'**il comprend les étapes successives suivantes :

a) On ajoute une solution S1 comprenant la molécule à cristalliser dans la chambre de dialyse (113) de la puce microfluidique (1) telle que définie à l'une quelconque des revendications 1 à 6 puis on l'encapsule,
b) Le cas échant, on injecte en continu une solution S2 dans les canaux de ladite puce microfluidique (1), ladite solution S2 contenant uniquement le tampon, la pression d'injection au niveau du canal microfluidique est maintenue inférieure à 400 mbar,
c) On injecte en continu une solution S3 de cristallisation, dans les canaux de ladite puce microfluidique (1), la pression d'injection au niveau du canal microfluidique est maintenue inférieure à 400 mbar ; La solution S3 de cristallisation contient au moins un agent de cristallisation et le cas échéant un ou plusieurs additifs, et éventuellement un tampon. Lorsque l'étape b) du procédé est mise en œuvre, la solution S3 comprend le tampon

de la solution S2 et au moins un agent de cristallisation et le cas échéant un ou plusieurs additifs.

**10.** Procédé de cristallisation selon la revendication 9, **caractérisé en ce que** lors de l'étape a) la chambre de dialyse est encapsulée par dépôt d'une lamelle de PMMA, puis revêtement KAPTON®.

**11.** Procédé de cristallisation selon l'une quelconque des revendications 9 à 10, **caractérisé en ce que**

- Lors de l'étape a), le cas échéant lors de l'étape b), la solution contenue dans la chambre de dialyse, comprenant ladite molécule à cristalliser, est à une première température T1 et à une concentration C1 de la molécule à cristalliser de telle sorte que la molécule à cristalliser se trouve dans la zone de sous-saturation (en dessous de la courbe de solubilité) du diagramme de phases de ladite molécule à cristalliser établi en fonction des paramètres de la concentration de la molécule à cristalliser et de la température ; lors de l'étape b), le tampon présent dans la solution S2 diffuse dans la solution contenue dans la chambre de dialyse et la molécule à cristalliser se trouve toujours dans ladite zone de sous-saturation,
- Lors de l'étape c), ladite solution de cristallisation S3 contient, les cas échéant en plus du tampon au moins un agent de cristallisation et le cas échéant un ou plusieurs additifs à une concentration P constante, de manière à ce que l'agent de cristallisation et le cas échéant l'additif diffuse dans la solution contenue dans la chambre de dialyse et de telle sorte que la molécule à cristalliser se trouve dans la zone de nucléation spontanée ou sur la limite supérieure de la zone métastable du diagramme de phases de ladite molécule à cristalliser et qu'apparaissent des germes de la molécule à cristalliser,

et le procédé comprend ensuite les étapes successives suivantes :

d) on augmente la température de la cellule de cristallisation (11) à une température T2 de telle sorte que la nucléation est arrêtée et que la molécule à cristalliser se trouve dans la zone métastable du diagramme de phases de la molécule à cristalliser,
e) s'il y a la formation de trop nombreux cristaux pendant l'étape c), la température de la cellule de cristallisation (11) peut être augmentée à une température >T2 de telle manière que la molécule à cristalliser se retrouve dans la zone de sous-saturation, juste en dessous de la courbe de solubilité, à nouveau et que l'excès de petits cristaux soient complètement dissout. Quelques cristaux sélectionnés, de tailles supérieures vont subir une dissolution partielle en évitant la dissolution complète et vont ensuite croitre dans la zone métastable par la baisse de température à la température T2,
f) On laisse grossir les germes de cristaux à la température T2 jusqu'à l'obtention d'un premier point d'équilibre E1, où la taille des cristaux demeure constante, la concentration de la molécule à cristalliser dans la solution contenue dans la chambre de dialyse atteinte étant alors la concentration C2,
g) On abaisse la température de la cellule de cristallisation (11) à une température T3, de telle sorte que les cristaux présents dans la chambre de dialyse (113) se situent toujours dans la zone métastable du diagramme de phases de la molécule à cristalliser,
h) On laisse grossir les germes de cristaux et les cristaux à la température T3 jusqu'à l'obtention d'un deuxième point d'équilibre E2 où la taille des cristaux demeure constante, la concentration de la molécule à cristalliser dans la solution contenue dans la chambre de dialyse atteinte étant alors la concentration C3,
i) On répète éventuellement les étapes f) à h),
j) On récupère la puce contenant les cristaux obtenus à l'issue de l'étape h) ou i) pour l'expérience de diffraction aux rayons X *in situ.*

**12.** Procédé de cristallisation selon l'une quelconque des revendications 9 à 10, **caractérisé en ce que**

- Lors de l'étape a), le cas échéant lors de l'étape b), la solution contenue dans la chambre de dialyse est à une température constante T de la cellule de cristallisation (11) et à une concentration C1 de la molécule à cristalliser de telle sorte que la molécule à cristalliser se trouve dans la zone de sous-saturation (en dessous de la courbe de solubilité) du diagramme de phases de ladite molécule à cristalliser établi en fonction des paramètres de la concentration de la molécule à cristalliser et de la concentration en agent de cristallisation et le cas échéant en additif ; lors de l'étape b), le tampon présent dans la solution S2 diffuse dans la solution contenue dans la chambre de dialyse et la molécule à cristalliser se trouve toujours dans ladite zone de sous-saturation,
- Lors de l'étape c), ladite solution de cristallisation S3 contient, le cas échéant en plus du tampon, au moins un agent de cristallisation et le cas échéant un ou plusieurs additifs à une concentration P1 dans le réservoir de la cellule de cristallisation, de manière à ce que l'agent de cristallisation et le cas échéant l'additif diffuse

dans la solution contenue dans la chambre de dialyse et de telle sorte que la molécule à cristalliser se trouve dans la zone de nucléation spontanée ou sur la limite supérieure de la zone métastable du diagramme de phases de ladite molécule à cristalliser et qu'apparaissent des germes de la molécule à cristalliser,
- Pour obtenir la nucléation spontanée contrôlée des cristaux la procédure suivante est employée : à l'aide du système de contrôle des écoulements des fluides la solution de cristallisation S3 est injectée en flux continu avec un gradient de concentration de l'agent de cristallisation et le cas échéant d'additif de manière à ce qu'à la concentration P1 seulement quelques cristaux se forment.

et le procédé comprend ensuite les étapes successives suivantes :

d) On diminue la concentration de l'agent de cristallisation et le échéant de l'additif à une concentration P2, de telle sorte que la nucléation est arrêtée et que la molécule à cristalliser se trouve dans la zone métastable dudit diagramme de phases de la molécule à cristalliser,
e) On laisse grossir les germes de cristaux à la concentration P2 de l'agent de cristallisation et le cas échéant de l'additif jusqu'à l'obtention d'un premier point d'équilibre E1, où la taille des cristaux demeure constante, la concentration de la molécule à cristalliser dans la solution contenue dans la chambre de dialyse atteinte étant alors la concentration C2,
f) On augmente la concentration de l'agent de cristallisation et le cas échéant de l'additif à une concentration P3, de telle sorte que les cristaux présents dans la cellule de cristallisation (11) se situent toujours dans la zone métastable dudit diagramme de phases de la molécule à cristalliser,
g) On laisse grossir les germes de cristaux et les cristaux à la concentration P3 de l'agent de cristallisation et le cas échéant de l'additif jusqu'à l'obtention d'un deuxième point d'équilibre E2 où la taille des cristaux demeure constante, la concentration de la molécule à cristalliser dans la solution contenue dans la chambre de dialyse atteinte est la concentration C3,
h) On répète éventuellement les étapes d) à f),
i) On récupère la puce contenant les cristaux obtenus à l'issue de l'étape g) ou h) pour l'expérience de diffraction aux rayons X *in situ.*

## Patentansprüche

1. Mikrofluidischer Chip (1), umfassend mindestens eine Dialyse-Kristallisationszelle (11), wobei die Zelle (11) umfasst:

   - einen Träger (1111) aus PMMA,
   - eine erste Etage, die einen Vorratsbehälter (111) umfasst, der mindestens zum Teil von dem Träger (1111) und von einer Außenwand (1112) der Zelle begrenzt ist, wobei der Vorratsbehälter (111) in Fluidkommunikation mit einem Einlasskanal und einem Auslasskanal einer Lösung ist, die die Durchführung des Kristallisationsverfahrens erlaubt,
   - eine zweite Etage, die eine Dialysekammer (113) umfasst, die mindestens zum Teil von einer Innenwand (1113) der Zelle ohne Kontakt mit dem Träger (1111) und von einer Dialysemembran (112) begrenzt wird, die eine Schnittstelle zwischen dem Vorratsbehälter (111) und der Dialysekammer (113) bildet, wobei die Innenwand (1113) mindestens einen einteiligen Abschnitt umfasst, in dem der Umfang der Membran (112) eingelassen gehalten wird.

2. Mikrofluidischer Chip (1) nach Anspruch 1, **dadurch gekennzeichnet, dass** die Dialysekammer eine Lösung eines zu kristallisierenden Moleküls enthält und dass die Dialysekammer von einer Polymerschicht aus PMMA (1115) eingefasst ist.

3. Mikrofluidischer Chip (1) nach einem der vorangehenden Ansprüche, **dadurch gekennzeichnet, dass** es einen Raum zwischen den Außen- (1112) und Innenwänden (1113) gibt, der auf einer Hauptoberfläche (1114) des Chips ausmündet und dass dieser Raum auf der Oberfläche des Chips über einen Anschluss mit dem Fluidströmungs-Kontrollsystem (1116) verbunden ist.

4. Mikrofluidischer Chip (1) nach einem der vorangehenden Ansprüche, **dadurch gekennzeichnet, dass** die Dialysemembran aus Cellulose, in vorteilhafter Weise aus regenerierter Cellulose, ist.

5. Mikrofluidischer Chip (1) nach Anspruch 1, **dadurch gekennzeichnet, dass** das Volumen der Dialysekammer zwischen 0,1 und 1 $\mu$L beträgt.

6. Mikrofluidischer Chip (1) nach einem der vorangehenden Ansprüche, **dadurch gekennzeichnet, dass** er mehrere Dialyse-Kristallisationszellen umfasst, die waagerecht und senkrecht aufgereiht sind.

7. Verfahren zur Herstellung eines mikrofluidischen Chips (1) nach einem der vorangehenden Ansprüche, **dadurch gekennzeichnet, dass** es die folgenden aufeinanderfolgenden Schritte umfasst:

- Herstellen von zwei Strukturblöcken aus luftdurchlässigem vernetztem Polymer PL, um die 3D-Puffer aus dem Polymer PL des oberen Teils zu erhalten, der die Dialysekammer definiert, und des unteren Teils des Chips, der die Kanäle und den /die Vorratsbehälter definiert,
- Aufbringen, auf dem Strukturblock mit den Kanälen und dem/den Vorratsbehälter(n), einer oder mehrere trockener Dialysemembranen,
- Platzieren des Strukturblocks ohne Kanäle in Übereinstimmung mit dem Strukturblock mit den Kanälen, so dass die Membran sandwichartig umschlossen wird,
- Aufbringen eines photosensiblen Harzes NOA81® auf die 3 Seiten zwischen den zwei Strukturblöcken, dann Initiieren der Vernetzung des Harzes NOA81®,
- Entfernen des oberen Teils des Strukturblocks mit der Verbindung aus vernetztem Harz durch Lösen des Ganzen vom unteren Strukturblock,
- Verschließen des sichtbaren Teils (ohne PL) mit einer Lamelle aus PMMA,
- Beenden der Vernetzung des Harzes NOA81®,
- Entfernen des letzten Strukturblocks.

8. Kristallisationsvorrichtung eines zu kristallisierenden Moleküls, die umfasst

- mindestens einen mikrofluidischen Chip nach einem der Ansprüche 1 bis 6,
- mindestens ein Hinzufügemittel, das eingerichtet ist, um in die Dialysekammer eine Lösung S1 hinzuzufügen, die das zu kristallisierende Molekül und eventuell mindestens einen Puffer umfasst,
- mindestens ein Hinzufüge-/Entnahmemittel, das mit Kristallisationsmittel und/oder Zusatz/Zusätzen und/oder Puffer(n) in den Kanälen eingerichtet ist, die zu der Kammer des Vorratsbehälters führen,
- mindestens ein Steuermittel der chemischen Zusammensetzung der Lösung im Vorratsbehälter, beispielsweise ein Dosier-, Variationsmittel der Konzentration der Puffer, der Kristallisationsmittel und der Zusätze,
- mindestens ein Steuer- und Variationsmittel der Temperatur des mikrofluidischen Chips nach einem der Ansprüche 1 bis 6,
- eventuell mindestens ein Messmittel der Konzentration des zu kristallisierenden Moleküls in der Lösung S1,
- mindestens ein Bilderfassungsmittel.

9. Kristallisationsverfahren eines zu kristallisierenden Moleküls, **dadurch gekennzeichnet, dass** es die folgenden aufeinanderfolgenden Schritte umfasst:

a) Hinzufügen einer Lösung S1, die das zu kristallisierende Molekül umfasst, in die Dialysekammer (113) des mikrofluidischen Chips (1) nach einem der Ansprüche 1 bis 6, dann Verkapseln derselben,
b) gegebenenfalls kontinuierliches Injizieren einer Lösung S2 in die Kanäle des mikrofluidischen Chips (1), wobei die Lösung S2 nur den Puffer enthält, wobei der Injektionsdruck im Bereich des mikrofluidischen Kanals unter 400 mbar gehalten wird,
c) kontinuierliches Injizieren einer Kristallisationslösung S3 in die Kanäle des mikrofluidischen Chips (1), wobei der Injektionsdruck im Bereich des mikrofluidischen Kanals unter 400 mbar gehalten wird; wobei die Kristallisationslösung S3 mindestens ein Kristallisationsmittel und gegebenenfalls einen oder mehrere Zusätze enthält, und eventuell einen Puffer. Wenn Schritt b) des Verfahrens durchgeführt wird, umfasst die Lösung S3 den Puffer der Lösung S2 und mindestens ein Kristallisationsmittel und gegebenenfalls einen oder mehrere Zusätze.

10. Kristallisationsverfahren nach Anspruch 9, **dadurch gekennzeichnet, dass** bei Schritt a) die Dialysekammer durch Aufbringen einer Lamelle aus PMMA, dann KAPTON®-Beschichtung verkapselt wird.

11. Kristallisationsverfahren nach einem der Ansprüche 9 bis 10, **dadurch gekennzeichnet, dass**

- bei Schritt a), gegebenenfalls bei Schritt b), die in der Dialysekammer enthaltene Lösung, die das zu kristallisierende Molekül umfasst, auf einer ersten Temperatur T1 und in einer Konzentration C1 des zu kristallisierenden Moleküls ist, so dass sich das zu kristallisierende Molekül in der Untersättigungszone (unterhalb der Löslichkeitskurve) des Phasendiagramms des zu kristallisierenden Moleküls befindet, die in Abhängigkeit der

Parameter der Konzentration des zu kristallisierenden Moleküls und der Temperatur erstellt wurde; bei Schritt b) sich der in der Lösung S2 vorhandene Puffer in der in der Dialysekammer enthaltenen Lösung verteilt und sich das zu kristallisierende Molekül weiterhin in der Untersättigungszone befindet,
- bei Schritt c) die Kristallisationslösung S3 gegebenenfalls zusätzlich zum Puffer mindestens ein Kristallisationsmittel und gegebenenfalls einen oder mehrere Zusätze in einer konstanten Konzentration P derart enthält, dass sich das Kristallisationsmittel und gegebenenfalls der Zusatz in der in der Dialysekammer enthaltenen Lösung verteilt und so dass sich das zu kristallisierende Molekül in der Spontannukleierungszone oder an der oberen Grenze der metastabilen Zone des Phasendiagramms des zu kristallisierenden Moleküls befindet und dass Nuklei des zu kristallisierenden Moleküls erscheinen;

und das Verfahren danach die folgenden aufeinanderfolgenden Schritte umfasst:

d) Erhöhen der Temperatur der Kristallisationszelle (11) auf eine Temperatur T2, so dass die Nukleierung gestoppt wird und sich das zu kristallisierende Molekül in der metastabilen Zone des Phasendiagramms des zu kristallisierenden Moleküls befindet,
e) wenn sich bei Schritt c) zu viele Kristalle bilden, kann die Temperatur der Kristallisationszelle (11) auf eine Temperatur >T2 derart erhöht werden, dass sich das zu kristallisierende Molekül erneut in der Untersättigungszone direkt unterhalb der Löslichkeitskurve befindet und der Überschuss kleiner Kristalle vollständig aufgelöst wird. Einige ausgewählte Kristalle größerer Größe werden teilweise aufgelöst, bei Vermeidung der vollständigen Auflösung, und werden danach in der metastabilen Zone durch Temperatursenkung auf die Temperatur T2 wachsen,
f) Wachsen lassen der Kristallnuklei bei der Temperatur T2 bis zum Erhalt eines ersten Gleichgewichtpunkts E1, bei dem die Größe der Kristalle konstant bleibt, wobei die erreichte Konzentration des zu kristallisierenden Moleküls in der in der Dialysekammer enthaltenen Lösung dann die Konzentration C2 ist,
g) Senken der Temperatur der Kristallisationszelle (11) auf eine Temperatur T3, so dass sich die in der Dialysekammer (113) vorhandenen Kristalle weiterhin in der metastabilen Zone des Phasendiagramms des zu kristallisierenden Moleküls befinden,
h) Wachsen lassen der Kristallnuklei und der Kristalle bei der Temperatur T3 bis zum Erhalt eines zweiten Gleichgewichtpunkts E2, bei dem die Größe der Kristalle konstant bleibt, wobei die erreichte Konzentration des zu kristallisierenden Moleküls in der in der Dialysekammer enthaltenen Lösung dann die Konzentration C3 ist,
i) eventuell Wiederholen der Schritte f) bis h),
j) Rückgewinnen des Chips, der die nach Abschluss von Schritt h) oder i) erhaltenen Kristalle enthält, für den *in situ*-Röntgenstrahl-Diffraktionsversuch.

**12.** Kristallisationsverfahren nach einem der Ansprüche 9 bis 10, **dadurch gekennzeichnet, dass**

- bei Schritt a), gegebenenfalls bei Schritt b), die in der Dialysekammer enthaltene Lösung auf einer konstanten Temperatur T der Kristallisationszelle (11) und in einer Konzentration C1 des zu kristallisierenden Moleküls ist, so dass sich das zu kristallisierende Molekül in der Untersättigungszone (unterhalb der Löslichkeitskurve) des Phasendiagramms des zu kristallisierenden Moleküls befindet, die in Abhängigkeit der Parameter der Konzentration des zu kristallisierenden Moleküls und der Konzentration des Kristallisationsmittels und gegebenenfalls des Zusatz erstellt wurde; bei Schritt b) sich der in der Lösung S2 vorhandene Puffer in der in der Dialysekammer enthaltenen Lösung verteilt und sich das zu kristallisierende Molekül weiterhin in der Untersättigungszone befindet,
- bei Schritt c) die Kristallisationslösung S3 gegebenenfalls zusätzlich zum Puffer mindestens ein Kristallisationsmittel und gegebenenfalls einen oder mehrere Zusätze in einer Konzentration P1 im Vorratsbehälter der Kristallisationszelle derart enthält, dass sich das Kristallisationsmittel und gegebenenfalls der Zusatz in der in der Dialysekammer enthaltenen Lösung verteilen und derart, dass sich das zu kristallisierende Molekül in der Spontannukleierungszone oder an der oberen Grenze der metastabilen Zone des Phasendiagramms des zu kristallisierenden Moleküls befindet und dass Nuklei des zu kristallisierenden Moleküls erscheinen;
- zum Erhalt der kontrollierten Spontannukleierung der Kristalle folgendes Verfahren angewendet wird: die Kristallisationslösung S3 wird mit Hilfe des Fluidströmungs-Kontrollsystems in kontinuierlichem Strom mit einem Konzentrationsgradienten des Kristallisationsmittels und gegebenenfalls Zusatz derart injiziert, dass sich bei der Konzentration P1 nur einige Kristalle bilden,

und das Verfahren danach die folgenden aufeinanderfolgenden Schritte umfasst:

d) Verringern der Konzentration des Kristallisationsmittels und gegebenenfalls des Zusatzes auf eine Konzentration P2, so dass die Nukleierung gestoppt wird und sich das zu kristallisierende Molekül in der metastabilen Zone des Phasendiagramms des zu kristallisierenden Moleküls befindet,

e) Wachsen lassen der Kristallnuklei bei der Konzentration P2 des Kristallisationsmittels und gegebenenfalls des Zusatzes bis zum Erhalt eines ersten Gleichgewichtpunkts E1, bei dem die Größe der Kristalle konstant bleibt, wobei die erreichte Konzentration des zu kristallisierenden Moleküls in der in der Dialysekammer enthaltenen Lösung dann die Konzentration C2 ist,

f) Erhöhen der Konzentration des Kristallisationsmittels und gegebenenfalls des Zusatzes auf eine Konzentration P3, so dass sich die in der Kristallisationszelle (11) vorhandenen Kristalle weiterhin in der metastabilen Zone des Phasendiagramms des zu kristallisierenden Moleküls befinden,

g) Wachsen lassen der Kristallnuklei und der Kristalle bei der Konzentration P3 des Kristallisationsmittels und gegebenenfalls des Zusatzes bis zum Erhalt eines zweiten Gleichgewichtpunkts E2, bei dem die Größe der Kristalle konstant bleibt, wobei die erreichte Konzentration des zu kristallisierenden Moleküls in der in der Dialysekammer enthaltenen Lösung dann die Konzentration C3 ist,

h) eventuell Wiederholen der Schritte d) bis f),

i) Rückgewinnen des Chips, der die nach Abschluss von Schritt g) oder h) erhaltenen Kristalle enthält, für den *in situ*-Röntgenstrahl-Diffraktionsversuch.

**Claims**

**1.** A microfluidic chip (1) comprising at least one dialysis crystallization cell (11), said cell (11) comprising:

- a support member (1111) made of PMMA
- a first level comprising a reservoir (111) defined at least in part by said support member (1111) and by an outer wall (1112) of the cell, said reservoir (111) being in fluid communication with an input channel and a output channel of a solution for implementing the crystallization method,
- a second level comprising a dialysis chamber (113) defined at least partially by an internal wall (1113) of the cell without contact with the support member (1111) and by a dialysis membrane (112) forming an interface between the reservoir (111) and the dialysis chamber (113), the inner wall (1113) comprising at least one one-piece portion in which the periphery of said membrane (112) is kept sealed.

**2.** A microfluidic chip (1) according to claim 1, **characterized in that** the dialysis chamber contains a solution of a molecule to be crystallized and **in that** the dialysis chamber is sealed by a PMMA polymer layer (1115).

**3.** A microfluidic chip (1) according to any one of the preceding claims, **characterized in that** there is a space between the outer (1112) and inner (1113) walls opening onto a main surface (1114) of the chip and **in that** this space, on the surface of the chip, is connected via a connection to the fluid flow control system (1116),

**4.** A microfluidic chip (1) according to any one of the preceding claims, **characterized in that** the dialysis membrane is cellulose, preferably regenerated cellulose.

**5.** A microfluidic chip (1) according to claim 1, **characterized in that** the volume of the dialysis chamber is between 0.1 and 1 $\mu$L.

**6.** A microfluidic chip (1) according to any one of the preceding claims, **characterized in that** it comprises a plurality of dialysis crystallization cells aligned in rows and columns.

**7.** A method for the preparation of a microfluidic chip (1) according to any one of the preceding claims, **characterized in that** it comprises the following successive steps :

- Making two structured blocks made of air-permeable crosslinked polymer PL to obtain the 3D buffers made of said polymer PL of the upper part which will define the dialysis chamber and the lower part of the chip that will define the channels and the reservoir(s),
- On the structured block with the channels and the reservoir(s), deposit one or more dry dialysis membrane(s),
- Place the structured block without channels alongside the structured block with the channels so as to sandwich the membrane,
- Place NOA81® photosensitive resin on 3 sides between the two structured blocks and then initiate the crosslinking of said NOA81® resin,

- Remove the upper part of the structured block with the crosslinked resin assembly by detaching the whole from the lower structured block,
- Close the visible part (without PL) with a slat of PMMA,
- Finalize the crosslinking of said NOA81® resin,
- Remove the last structured block

**8.** A crystallization device for a molecule to be crystallized which comprises

- At least one microfluidic chip according to any one of claims 1 to 6,
- At least one adding means arranged for adding a solution S1 comprising the molecule to be crystallized and optionally at least one buffer to the dialysis chamber;
- At least one arranged means for adding/removing crystallization agent and/or additive(s) and/or buffer(s) in the channels leading to the chamber of the reservoir;
- At least one means for controlling the chemical composition of the solution in the reservoir, for example a means for proportioning, varying the concentration of the buffers, crystallization agents, and additives;
- At least one means for controlling and varying the temperature of the microfluidic chip according to any one of claims 1 to 6.
- Possibly at least one means for measuring the concentration of the molecule to be crystallized in the solution S1,
- At least one means for acquiring images.

**9.** A method for crystallization of a molecule to be crystallized, **characterized in that** it comprises the following successive steps:

a) A solution S1 comprising the molecule to be crystallized in the dialysis chamber (113) of the microfluidic chip (1) as defined in any one of claims 1 to 6 is added and then encapsulated.
b) If necessary, a solution S2 is continuously injected into the channels of said microfluidic chip (1), said solution S2 containing only the buffer, the injection pressure at the level of the microfluidic channel is kept below 400 mbar.
c) A solution S3 of crystallization is continuously injected into the channels of said microfluidic chip (1), the injection pressure at the microfluidic channel is kept below 400 mbar; the crystallization solution S3 contains at least one crystallization agent and optionally one or more additives, and optionally a buffer. When step b) of the method is implemented, the solution S3 comprises the buffer of the solution S2 and at least one crystallization agent and optionally one or more additives.

**10.** Crystallization method according to claim 9, **characterized in that** during step a) the dialysis chamber is encapsulated by deposing a PMMA slat, then KAPTON® coating.

**11.** Crystallization method according to one of Claims 9 to 10, **characterized in that**

- During step a), if necessary during step b), the solution contained in the dialysis chamber, comprising said molecule to be crystallized, is at a first temperature T1 and at a concentration C1 of the molecule to be crystallized so that the molecule to be crystallized is in the undersaturation zone (below the solubility curve) of the phase diagram of said molecule to be crystallized established as a function of the parameters of the concentration of the molecule to be crystallized and of the temperature; during step b), the buffer present in the solution S2 diffuses into the solution contained in the dialysis chamber and the molecule to be crystallized is always in said under-saturation zone,
- In step c), said crystallization solution S3 optionally contains in addition to the buffer at least one crystallization agent and if necessary one or more additives at a constant concentration P, so that the crystallization agent and if necessary the diffuse additive in the solution contained in the dialysis chamber and such that the molecule to be crystallized is in the spontaneous nucleation zone or at the upper limit of the metastable zone of the phase diagram said molecule to be crystallized and that seeds of the molecule to be crystallized appear;

and the method then comprises the following successive steps:

d) the temperature of the crystallization cell (11) is raised to a temperature T2 so that the nucleation is stopped and the molecule to be crystallized is in the metastable zone of the phase diagram of the molecule to be crystallized,
e) if there is formation of too many crystals during step c), the temperature of the crystallization cell (11) can be raised to a temperature >T2 in such a way that the molecule to be crystallized is found in the undersaturation

zone, just below the solubility curve, again and the excess of small crystals is completely dissolved. Some selected crystals, of larger sizes will undergo a partial dissolution avoiding complete dissolution and will then grow in the metastable zone due to the fall in temperature to the temperature T2,

f) The crystal seeds are allowed to grow at the temperature T2 until a first equilibrium point E1 is obtained, where the crystal size remains constant, the concentration of the molecule to be crystallized in the solution contained in the dialysis chamber in question then being the concentration C2,

g) The temperature of the crystallization cell (11) is lowered to a temperature T3, so that the crystals present in the dialysis chamber (113) are always in the metastable zone of the phase diagram of the molecule to de crystallized,

h) The crystal seeds and the crystals are allowed to grow at the temperature T3 until a second equilibrium point E2 is reached in which the crystal size remains constant, the concentration of the molecule to be crystallized in the solution contained in the dialysis chamber in question then being the concentration C3,

i) Steps f) to h) are repeated,

j) The chip containing the crystals obtained at the end of step h) or i) is recovered for the X-ray diffraction experiment *in situ.*

**12.** Crystallization method according to one of claims 9 to 11, **characterized in that**

- During step a), if necessary during step b), the solution contained in the dialysis chamber is at a constant temperature T of the crystallization cell (11) and at a concentration C1 of the molecule to be crystallized so that the molecule to be crystallized is in the zone of undersaturation (below the solubility curve) of the phase diagram of said molecule to be crystallized established as a function of the parameters of the concentration of the molecule to be crystallized and the concentration of crystallization agent and of additive if necessary; during step b), the buffer present in the solution S2 diffuses into the solution contained in the dialysis chamber and the molecule to be crystallized is always in said undersaturation zone
- In step c), said crystallization solution S3 contains, where appropriate in addition to the buffer, at least one crystallization agent and optionally one or more additives at a concentration P1 in the reservoir of the crystallization cell so that the crystallization agent and optionally the additive diffuses into the solution contained in the dialysis chamber and so that the molecule to be crystallized is in the spontaneous nucleation zone or at the upper limit of the metastable zone of the phase diagram of said molecule to be crystallized and that seeds of the molecule to be crystallized appear;
- In order to obtain controlled spontaneous nucleation of the crystals, the following procedure is employed: using the fluid flow control system, the crystallization solution S3 is injected in continuous flow with a concentration gradient of the crystallization agent and if necessary the additive so that, at the concentration P1, only a few crystals form.

and the method then comprises the following successive steps:

d) The concentration of the crystallization agent and the additive are reduced to a concentration P2, so that the nucleation is stopped and the molecule to be crystallized is in the metastable zone of said phase diagram of the molecule to crystallize,

e) The crystal seeds are allowed to grow at the concentration P2 of the crystallization agent and, if necessary, of the additive until a first equilibrium point E1 is obtained, where the crystal size remains constant, the concentration of the molecule to be crystallized in the solution contained in the dialysis chamber in question then being the concentration C2,

f) The concentration of the crystallization agent and, if necessary, the additive is increased to a concentration P3, so that the crystals present in the crystallization cell (11) are always in the metastable zone of said crystal phrase diagram of the molecule to be crystallized,

g) The crystal seeds and the crystals are allowed to grow at the concentration P3 of the crystallization agent and, if necessary, of the additive until a second equilibrium point E2 is obtained, where the size of the crystals remains constant, the concentration of the molecule to be crystallized in the solution contained in the dialysis chamber in question is the concentration C3,

h) The steps d) to f) are repeated if necessary,

i) The chip containing the crystals obtained at the end of step g) or h) is recovered for the X-ray diffraction experiment *in situ.*

FIG. 1

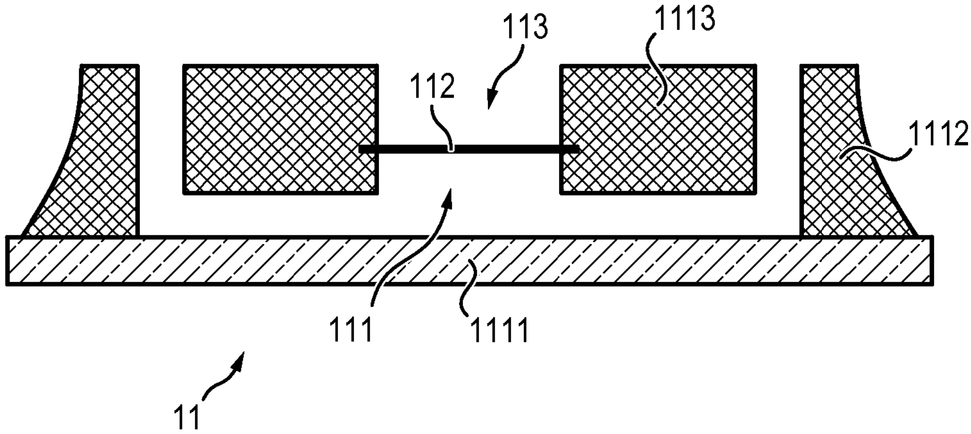
113
1113
112
1112
111
1111
11

FIG. 2

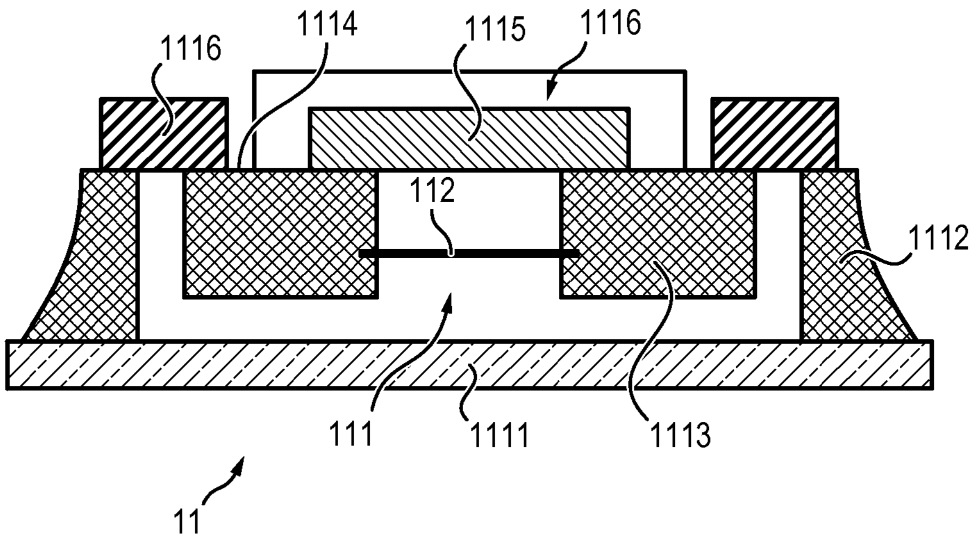
1116
1114
1115
1116
112
1112
111
1111
1113
11

FIG. 3

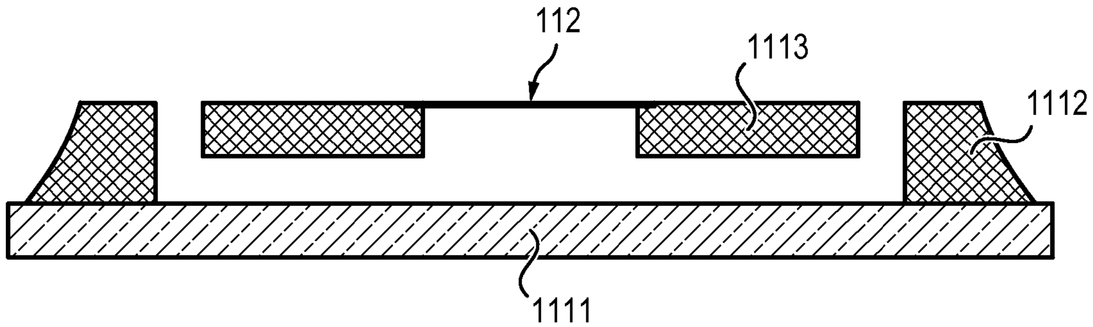


FIG. 4A

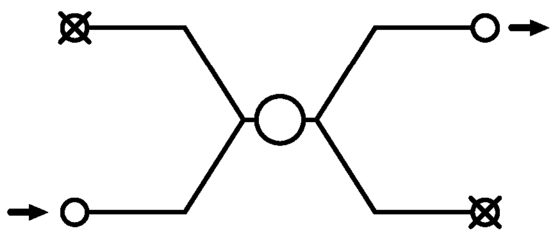

FIG. 4B

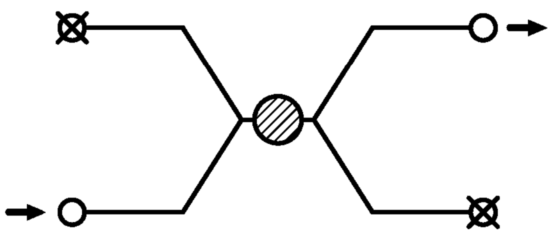

FIG. 4C

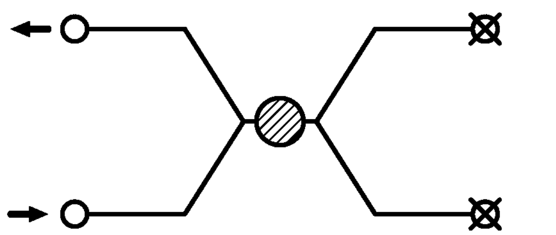

FIG. 4D

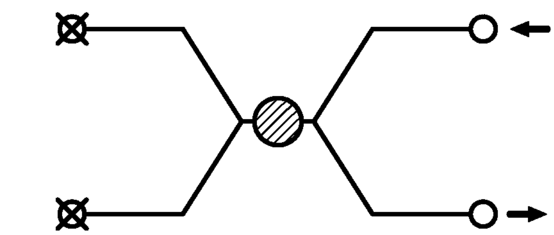

FIG. 5

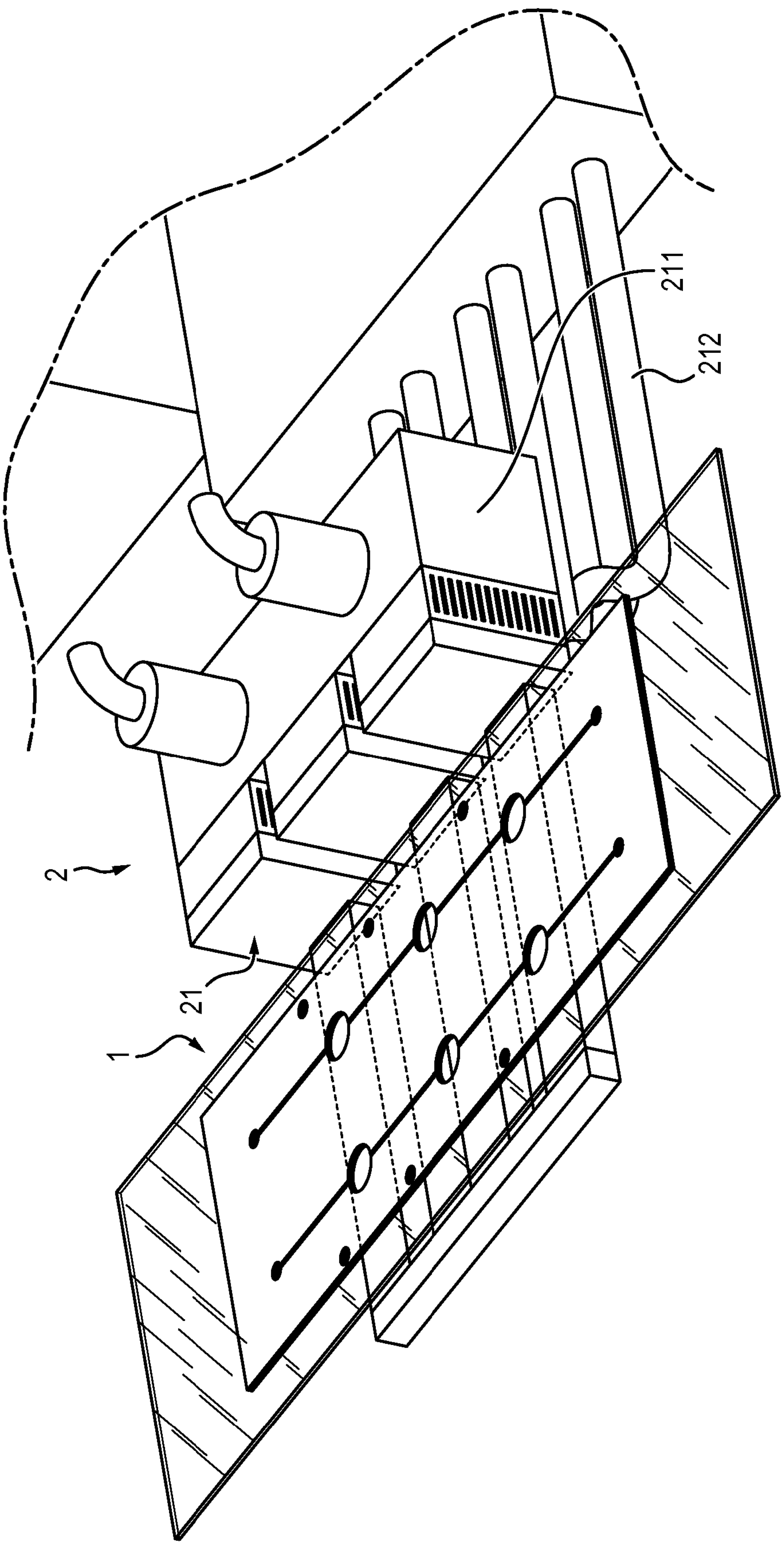

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2012035268 A
- US 2014080206 A


### Littérature non-brevet citée dans la description


- **LONGUET et al.** spatially-controlled protein crystallisation in microfluidic chambers. *journal of crystal growth,* vol. 386, 179-182